(19) Europäisches Patentamt
European Patent Office
Office européen des brevets

(11) EP 4 249 569 A1

(12) **EUROPEAN PATENT APPLICATION**
published in accordance with Art. 153(4) EPC

(43) Date of publication:
**27.09.2023 Bulletin 2023/39**

(21) Application number: **21894474.2**

(22) Date of filing: **04.11.2021**

(51) International Patent Classification (IPC):
***C09K 11/08*** *(2006.01)* ***C09K 11/66*** *(2006.01)*
***G02B 5/20*** *(2006.01)*

(52) Cooperative Patent Classification (CPC):
**C09K 11/08; C09K 11/66; G02B 5/20**

(86) International application number:
**PCT/JP2021/040512**

(87) International publication number:
**WO 2022/107600 (27.05.2022 Gazette 2022/21)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **18.11.2020 JP 2020191792**

(71) Applicant: **DIC Corporation**
**Tokyo 174-8520 (JP)**

(72) Inventors:
- **NONAKA, Yuki**
  **Sakura-shi, Chiba 285-8668 (JP)**
- **HAYASHI, Takuo**
  **Sakura-shi, Chiba 285-8668 (JP)**
- **HORIGUCHI, Masahiro**
  **Sakura-shi, Chiba 285-8668 (JP)**

(74) Representative: **TBK**
**Bavariaring 4-6**
**80336 München (DE)**

(54) **LUMINESCENT PARTICLES AND PRODUCTION METHOD THEREFOR, LUMINESCENT-PARTICLE DISPERSION, PHOTOCONVERSION FILM, LAYERED PRODUCT, PHOTOCONVERSION LAYER, COLOR FILTER, AND LUMINESCENT ELEMENT**

(57) Provided is a method for producing light-emitting particles made of semiconductor nanocrystal particles composed of a metal halide and having excellent dispersibility and stability. A method for producing light-emitting particles each having a surface layer containing Si on a surface of a semiconductor nanocrystal particle composed of a metal halide includes the steps of: forming the semiconductor nanocrystal particle and a polysiloxane bond from a solution containing a raw material for the semiconductor nanocrystal particle, a silane compound A having a binding group and a hydrolyzable silyl group, and a solvent, to obtain a precursor particle; mixing the precursor particle, a polymer B containing a structural unit having a basic group and a solvophilic structural unit, and a solvent to obtain a mixture; and adding a silane compound C having a hydrolyzable silyl group to the mixture to obtain a light-emitting particle having a layer containing the polymer B and a polymer of the silane compound C on a surface of the precursor particle.

【Fig. 1】

50

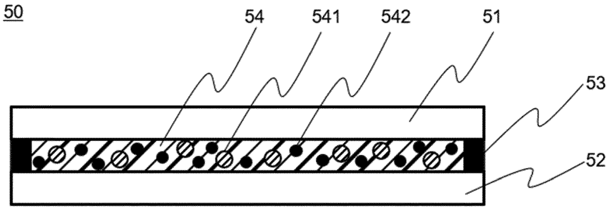


EP 4 249 569 A1

## Description

### Technical Field

The present invention relates to light-emitting particles and a method for producing the same, a light-emitting particle dispersion, a light conversion film, a laminate, a light conversion layer, a color filter, and a light-emitting element.

### Background Art

In recent years, semiconductor nanocrystals composed of a metal halide and having a perovskite-type crystal structure have been found and attracted attention (see, for example, PTL 1). The perovskite-type semiconductor nanocrystals are composed of, for example, a compound represented by $CsPbX_3$ (where X is Cl, Br, or I). The emission wavelength of the perovskite-type semiconductor nanocrystals can be controlled by adjusting the abundance ratio of halogen atoms, in addition to the particle size. Since this adjustment operation can be easily performed, the perovskite-type semiconductor nanocrystals are characterized in that the emission wavelength is more easily controlled and therefore the productivity is higher than core shell-type semiconductor nanocrystals.

### Citation List

### Patent Literature

PTL 1: Japanese Unexamined Patent Application No. 2017-222851

### Summary of Invention

### Technical Problem

Semiconductor nanocrystal particles composed of a metal halide may be used in a dispersed state in a dispersion medium (e.g., as an ink composition). It is therefore desirable that the semiconductor nanocrystal particles are suitably dispersed in a dispersion medium. In addition, the semiconductor nanocrystal particles are easily destabilized by heat and polar solvents such as water, which may lead to decrease in the quantum yield of the semiconductor nanocrystal particles. It is therefore requested that the stability of light-emitting particles made of semiconductor nanocrystal particles composed of a metal halide should be enhanced.

An object of the present invention is to provide light-emitting particles with excellent dispersibility and stability and made of semiconductor nanocrystal particles composed of a metal halide and a method for producing the same, a light-emitting particle dispersion containing the light-emitting particles, a light conversion film, a laminated structure, a light conversion layer, a color filter, and a light-emitting element.

### Solution to Problem

A method for producing light-emitting particles of the present invention is a method for producing light-emitting particles each having a surface layer containing Si on a surface of a semiconductor nanocrystal particle composed of a metal halide. The method includes the steps of: forming the semiconductor nanocrystal particle and a polysiloxane bond on a surface of the semiconductor nanocrystal particle, from a solution containing a raw material compound for the semiconductor nanocrystal particle, a silane compound A having a binding group capable of binding to the surface of the semiconductor nanocrystal particle and a hydrolyzable silyl group, and a solvent, to obtain a precursor particle having a layer containing a polymer of the silane compound A on the surface of the semiconductor nanocrystal particle; mixing the precursor particle, a polymer B containing a first structural unit having a basic group and a second structural unit having no basic group and being solvophilic, and a solvent to obtain a mixture; and adding a silane compound C having a hydrolyzable silyl group to the mixture and forming a polysiloxane bond to obtain a light-emitting particle having a layer containing the polymer B and a polymer of the silane compound C on a surface of the precursor particle.

It is preferable that the silane compound A is a compound represented by the following formula (A1).

[chem. 1]

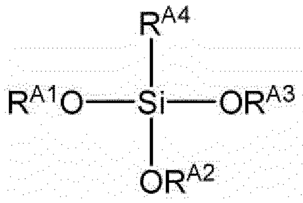

(A1)

In the formula, $R^{A1}$, $R^{A2}$, and $R^{A3}$ each independently represent a hydrogen atom or an alkyl group having 1 to 6 carbon atoms, and $R^{A4}$ represents a monovalent group having the binding group.

It is preferable that the binding group is at least one selected from the group consisting of a carboxyl group, a mercapto group, and an amino group.

It is preferable that the silane compound C is a compound represented by the following formula (C1).

[chem. 2]

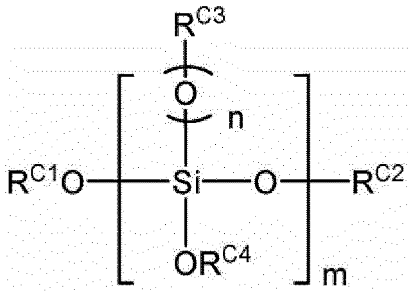

(C1)

In the formula, $R^{C1}$ and $R^{C2}$ each independently represent an alkyl group, $R^{C3}$ and $R^{C4}$ each independently represent a hydrogen atom or an alkyl group, n represents 0 or 1, and m represents an integer of 1 or more.

Light-emitting particles of the present invention are particles obtained by the production method described above.

A light-emitting particle dispersion of the present invention contains the light-emitting particles described above and a dispersion. In the light-emitting particle dispersion, it is preferable that the dispersion medium is a solvent or a photopolymerizable compound. It is preferable that the light-emitting particle dispersion contains at least a photopolymerizable compound as the dispersion and further contains a photopolymerization initiator.

A light conversion film of the present invention contains a polymer of the light-emitting particle dispersion described above.

A laminated structure of the present invention includes the light conversion film described above.

A light-emitting element of the present invention includes the laminated structure described above.

A light conversion layer of the present invention includes a plurality of pixel units and a light-shielding unit disposed between the pixel units. The pixel units include a light-emitting pixel unit containing a cured product of the light-emitting particle dispersion described above.

A color filter of the present invention includes the light conversion layer described above.

A light-emitting element of the present invention includes the color filter described above.

Advantageous Effects of Invention

According to an aspect of the present invention, light-emitting particles with excellent dispersibility and stability and made of semiconductor nanocrystal particles composed of a metal halide and a method for producing the same, a light-emitting particle dispersion containing the light-emitting particles, a light conversion film, a laminated structure, a light conversion layer, a color filter, and a light-emitting element can be provided.

Brief Description of Drawings

Fig. 1 is a cross-sectional view schematically illustrating a configuration of a laminated structure of the present

embodiment.

Fig. 2 is a schematic cross-sectional view of a color filter of an embodiment of the present invention.

Fig. 3 is an image illustrating an element distribution by STEM-EDS of a light-emitting particle.

## Description of Embodiments

Embodiments of the present invention will be described below. The present invention is not limited by the following embodiments.

### <Method for Producing Light-Emitting Particles>

An embodiment of the present invention is a method for producing light-emitting particles each having a surface layer containing Si on a surface of a semiconductor nanocrystal particle composed of a metal halide. The production method according to an embodiment includes step S1 of forming a semiconductor nanocrystal particle and a polysiloxane bond on a surface of the semiconductor nanocrystal particle, from a solution containing a raw material compound for semiconductor nanocrystal particles, a silane compound A having a binding group capable of binding to the surface of the semiconductor nanocrystal particle and a hydrolyzable silyl group, and a solvent, to obtain a precursor particle having a layer containing a polymer of the silane compound A on the surface of the semiconductor nanocrystal particle, step S2 of mixing the precursor particle, a polymer B containing a first structural unit having a basic group and a second structural unit having no basic group and being solvophilic, and a solvent to obtain a mixture, and step S3 of adding a silane compound C having a hydrolyzable silyl group to the mixture and forming a polysiloxane bond to obtain a light-emitting particle having a layer containing the polymer B and a polymer of the silane compound C on a surface of the precursor particle.

#### <<Step S1>>

In step S1, for example, a first solution containing a raw material compound for semiconductor nanocrystal particles and a second solution containing a silane compound A are mixed to generate semiconductor nanocrystal particles composed of a metal halide and to coordinate the silane compound A on a surface of each semiconductor nanocrystal particle. Subsequently, a hydrolyzable silyl group in the coordinated silane compound A is condensed to form a siloxane bond. Through the above step, a precursor particle having a layer containing a polymer of the silane compound A on the surface of the semiconductor nanocrystal is obtained.

In step S1, the first solution and the second solution may be heated or may not be heated when mixed. When the first solution and the second solution are heated when mixed, for example, the first solution may contain a part of the raw material compound for semiconductor nanocrystal particles, and the second solution may contain the remaining part of the raw material compound for semiconductor nanocrystal particles in addition to the silane compound A. These solutions are then mixed under an inert gas atmosphere and reacted under a temperature condition of, for example, 130 to 260°C. The reaction solution is then cooled to -20 to 30°C and stirred to generate semiconductor nanocrystal particles, and after the silane compound A is bonded to the surface of the semiconductor nanocrystal particle, the hydrolyzable silyl group in the silane compound A is condensed to form a siloxane bond.

Specifically, for example, a solution containing cesium carbonate, which is a part of the raw material compound, a compound that acts as a ligand for the semiconductor nanocrystal particle, and an organic solvent is prepared. As the compound that acts as a ligand for the semiconductor nanocrystal particle, oleic acid, oleylamine, or the like can be used. As the organic solvent, 1-octadecene, dioctyl ether, diphenyl ether, or the like can be used. In this case, it is preferable that the addition amounts are adjusted so that 0.2 to 2 g of the raw material compound such as cesium carbonate and 0.1 to 10 mL of the compound that acts as a ligand, such as oleic acid, are added to 40 mL of the organic solvent. The resulting solution is dried under reduced pressure at 90 to 150°C for 10 to 180 minutes, and then heated to 100 to 200°C under an inert gas atmosphere such as argon or nitrogen to obtain a cesium-oleic acid solution.

Meanwhile, a solution containing lead(II) bromide, which is the remainder of the raw material compound, a compound that acts as a ligand for the semiconductor nanocrystal particle, and an organic solvent is prepared. The compound that acts as a ligand for the semiconductor nanocrystal particle and the organic solvent are the same as the organic solvent used in the preparation of the solution containing cesium carbonate. To 5 mL of the organic solvent, 20 to 100 mg of the raw material compound such as lead(II) bromide and 0.1 to 10 mL of the compound that acts as a ligand, such as oleic acid, are added. The resulting solution is dried under reduced pressure at 90 to 150°C for 10 to 180 minutes, and then 0.1 to 2 mL of 3-aminopropyltriethoxysilane, which is the silane compound A, is added under an inert gas atmosphere such as argon or nitrogen.

While the solution containing lead(II) bromide and 3-aminopropyltriethoxysilane is heated to 130 to 260°C, the cesium-oleic acid solution described above is added and reacted by stirring with heating for 1 to 10 seconds. The resulting

reaction solution is then cooled in an ice bath. In this case, it is preferable that 0.1 to 1 mL of the cesium-oleic acid solution is added to 5 mL of the solution containing lead(II) bromide, oleic acid, and 3-aminopropyltriethoxysilane. During stirring at -20 to 30°C, semiconductor nanocrystal particles are generated and 3-aminopropyltriethoxysilane and oleic acid are coordinated on the surface of each semiconductor nanocrystal particle.

Subsequently, 0.1 to 60 mL of methyl acetate is added to the resulting reaction solution to obtain a suspension. The resulting suspension is centrifuged and then the supernatant is removed to obtain a solid matter containing precursor particles.

When the first solution and the second solution are not heated when mixed, the first solution containing the raw material compound for semiconductor nanocrystal particles and the second solution containing the silane compound A are first mixed in the air. The resulting mixture is then added to a large amount of an organic solvent, which is a poor solvent for semiconductor nanocrystal particles, to generate semiconductor nanocrystal particles. It is preferable that the amount of the organic solvent used is 10 to 1000 times the amount of semiconductor nanocrystal particles on a mass basis. A siloxane bond is formed between the hydrolyzable silyl groups of the silane compound A on the surface of the generated semiconductor nanocrystal particle.

Specifically, as the first solution containing the raw material compound for semiconductor nanocrystal particles, for example, a solution containing lead(II) bromide and methylamine hydrobromide, which are a part of the raw material compound, and an organic solvent is prepared. The organic solvent may be any good solvent for nanocrystals, but dimethyl sulfoxide, N,N-dimethylformamide, N-methylformamide, and a mixed solvent thereof are preferred in terms of compatibility. In this case, it is preferable that the addition amounts are adjusted so that 50 to 200 mg of lead(II) bromide and 10 to 100 mg of methylamine hydrobromide are added to 10 mL of the organic solvent.

On the other hand, as the second solution containing the silane compound A, for example, a solution containing 3-aminopropyltriethoxysilane, a ligand that acts for a semiconductor nanocrystal particle, and a poor solvent is prepared. As the ligand that acts for the semiconductor nanocrystal particle, for example, oleic acid, oleylamine, or the like can be used. As the poor solvent, isopropyl alcohol, toluene, hexane, cyclohexane, methyl acetate, ethyl acetate, butyl acetate, acetone, acetonitrile, or the like can be used. In this case, the addition amounts are adjusted so that 0.01 to 0.5 mL of the silane compound A such as 3-aminopropyltriethoxysilane and 0.01 to 0.5 mL of the ligand such as oleic acid are added to 5 mL of the poor solvent.

Then, to 0.1 to 5 mL of the solution containing lead(II) bromide and methylamine hydrobromide, 5 mL of the solution containing 3-aminopropyltriethoxysilane is added at 0 to 60°C in the air to obtain a mixture. Immediately after that, the resulting mixture is added to a large amount of a poor solvent and centrifuged, and then the supernatant is removed to obtain a solid matter containing precursor particles. When the mixture is added to a large amount of a poor solvent, semiconductor nanocrystal particles are precipitated and 3-aminopropyltriethoxysilane and oleic acid are coordinated on the surface of the semiconductor nanocrystal particle. The alkoxysilyl group of 3-aminopropyltriethoxysilane is then condensed to form a siloxane bond between hydrolyzable silyl groups of the silane compound A on the surface of the semiconductor nanocrystal particle.

The semiconductor nanocrystal particle composed of a metal halide generated in step S1 is a nano-size crystal (nanocrystal particle) that absorbs excitation light and emits fluorescence or phosphorescence. The semiconductor nanocrystal particle is a particle with a maximum particle size of 100 nm or less as measured, for example, by a transmission electron microscope or a scanning electron microscope. The semiconductor nanocrystal particle can be excited by, for example, light energy or electrical energy of a predetermined wavelength and emit fluorescence or phosphorescence.

The semiconductor nanocrystal particle composed of a metal halide is formed of a compound represented by the general formula $A_aM_bX_c$.

In the formula, A is at least one of organic cations and metal cations. Examples of the organic cations include ammonium, formamidinium, guanidinium, imidazolium, pyridinium, pyrrolidinium, and protonated thiourea, and examples of the metal cations include cations of Cs, Rb, K, Na, Li, and the like.

M is at least one of metal cations. Examples of the metal cations include metal cations selected from groups 1, 2, 3, 4, 5, 6, 7, 8, 9, 10, 11, 13, 14, and 15. More preferably, examples include cations of Ag, Au, Bi, Ca, Ce, Co, Cr, Cu, Eu, Fe, Ga, Ge, Hf, In, Ir, Mg, Mn, Mo, Na, Nb, Nd, Ni, Os, Pb, Pd, Pt, Re, Rh, Ru, Sb, Sc, Sm, Sn, Sr, Ta, Te, Ti, V, W, Zn, Zr, and the like.

X is at least one of anions. Examples of the anions include chloride ion, bromide ion, iodide ion, and cyanide ion, and the anions include at least one of halogens.

a is an integer of 1 to 7, b is an integer of 1 to 4, and c is an integer of 3 to 16.

The emission wavelength (emission color) of the semiconductor nanocrystal particle can be controlled by adjusting the particle size, and the type and abundance ratio of the anions represented by X.

To the compound composed of a metal halide represented by the general formula $A_aM_bX_c$, metal ions such as Bi, Mn, Ca, Eu, Sb, and Yb, different from the metal cations used for the M site, may be added (doped) in order to improve the light-emitting properties.

Among metal halides represented by the general formula $A_aM_bX_c$, a compound having a perovskite-type crystal structure is particularly preferable for use as light-emitting particles, in that the emission wavelength (emission color) can be controlled by adjusting the particle size, and the type and abundance ratio of metal cations constituting the M site, and further adjusting the type and abundance ratio of anions constituting the X site. Since this adjustment operation can be easily performed, the perovskite-type semiconductor nanocrystal is characterized in that the emission wavelength is more easily controlled and therefore the productivity is higher than conventional core shell-type semiconductor nanocrystals.

Specifically, compounds represented by $AMX_3$, $A_3MX_5$, $A_3MX_6$, $A_4MX_6$, and $A_2MX_6$ are preferred. A, M, and X in the formula are as described above. Metal ions such as Bi, Mn, Ca, Eu, Sb, and Yb, different from the metal cations used for the M site, may be added (doped) to the compound having a perovskite-type crystal structure.

Among compounds exhibiting a perovskite-type crystal structure, it is preferable that A is Cs, Rb, K, Na, or Li, M is one metal cation ($M^1$) or two metal cations ($M^1_\alpha M^2_\beta$), and X is chloride ion, bromide ion, or iodide ion in order to exhibit even better light-emitting properties. Here, $\alpha$ and $\beta$ each represent a real number of 0 to 1, and $\alpha+\beta=1$. Specifically, it is preferable that M is selected from Ag, Au, Bi, Cu, Eu, Fe, Ge, K, In, Na, Mn, Pb, Pd, Sb, Si, Sn, Yb, Zn, and Zr.

As a specific composition of the semiconductor nanocrystal particle composed of a metal halide that exhibits a perovskite-type crystal structure, a semiconductor nanocrystal particle using Pb as M, such as $CsPbBr_3$, $CH_3NH_3PbBr_3$, and $CHN_2H_4PbBr_3$, is preferred because of excellent light intensity and excellent quantum efficiency. The semiconductor nanocrystal particle using a metal cation other than Pb as M, such as $CsSnBr_3$ and $CsEuBr_3CsYbI_3$, is also preferred because of low toxicity and little environmental impact.

The semiconductor nanocrystal particle may be a red light-emitting crystal that emits light having an emission peak in the wavelength range of 605 to 665 nm (red light), may be a green light-emitting crystal that emits light having an emission peak in the wavelength range of 500 to 560 nm (green light), and may be a blue light-emitting crystal that emits light having an emission peak in the wavelength range of 420 to 480 nm (blue light). In one embodiment, a combination of these nanocrystals may be used.

The wavelength of the emission peak of the semiconductor nanocrystal particle can be identified, for example, in the fluorescence spectrum or the phosphorescence spectrum measured using an absolute PL quantum yield measuring device.

The red light-emitting semiconductor nanocrystal particles preferably have an emission peak in the wavelength range of 665 nm or less, 663 nm or less, 660 nm or less, 658 nm or less, 655 nm or less, 653 nm or less, 651 nm or less, 650 nm or less, 647 nm or less, 645 nm or less, 643 nm or less, 640 nm or less, 637 nm or less, 635 nm or less, 632 nm or less, or 630 nm or less and preferably have an emission peak in the wavelength range of 628 nm or more, 625 nm or more, 623 nm or more, 620 nm or more, 615 nm or more, 610 nm or more, 607 nm or more, or 605 nm or more.

These upper limit values and lower limit values can be combined as desired. In the similar description below, the upper limit values and lower limit values described individually can be combined as desired.

The green light-emitting semiconductor nanocrystal particles preferably have an emission peak in the wavelength range of 560 nm or less, 557 nm or less, 555 nm or less, 550 nm or less, 547 nm or less, 545 nm or less, 543 nm or less, 540 nm or less, 537 nm or less, 535 nm or less, 532 nm or less, or 530 nm or less and preferably have an emission peak in the wavelength range of 528 nm or more, 525 nm or more, 523 nm or more, 520 nm or more, 515 nm or more, 510 nm or more, 507 nm or more, 505 nm or more, 503 nm or more, or 500 nm or more.

The blue light-emitting semiconductor nanocrystal particles preferably have an emission peak in the wavelength range of 480 nm or less, 477 nm or less, 475 nm or less, 470 nm or less, 467 nm or less, 465 nm or less, 463 nm or less, 460 nm or less, 457 nm or less, 455 nm or less, 452 nm or less, or 450 nm or less and preferably have an emission peak in the wavelength range of 450 nm or more, 445 nm or more, 440 nm or more, 435 nm or more, 430 nm or more, 428 nm or more, 425 nm or more, 422 nm or more, or 420 nm or more.

The shape of the semiconductor nanocrystal particle is not limited and may be any geometric shape or may be any irregular shape. Examples of the shape of the semiconductor nanocrystal particle include a rectangular parallelepiped shape, a cube shape, a spherical shape, a regular tetrahedron shape, an ellipsoidal shape, a pyramid shape, a disc shape, a branch shape, a net shape, and a rod shape. The shape of the semiconductor nanocrystal particle is preferably a shape having little directionality (e.g., a spherical shape, a tetrahedron shape, etc.). By using the semiconductor nanocrystal particles having such a shape, the light-emitting particles reflecting the shape can be obtained, and uniform dispersibility and fluidity can be further enhanced when an ink composition containing such light-emitting particles is prepared.

The average particle size (volume average diameter) of the semiconductor nanocrystal particles is preferably 40 nm or less, more preferably 30 nm or less, and even more preferably 20 nm or less. The average particle size of the semiconductor nanocrystal particles is preferably 1 nm or more, more preferably 1.5 nm or more, and even more preferably 2 nm or more. The semiconductor nanocrystal particles having such an average particle size are preferable since they easily emit light having a desired wavelength.

The average particle size of the semiconductor nanocrystal particles is determined by measuring the particle

size using a transmission electron microscope or a scanning electron microscope and calculating the volume average diameter.

It is preferable that a ligand is coordinated on the surface of the semiconductor nanoparticle in order to enhance the stability. The semiconductor nanoparticle having a ligand coordinated on the surface can be generated by adding a ligand to the first solution and/or the second solution containing the raw material compound for semiconductor nanocrystal particles.

The ligand is preferably a compound having a binding group that binds to a cation contained in the semiconductor nanocrystal. For example, the binding group is preferably at least one of a carboxyl group, a carboxylic anhydride group, an amino group, an ammonium group, a mercapto group, a phosphine group, a phosphine oxide group, a phosphoric acid group, a phosphonic acid group, a phosphinic acid group, a sulfonic acid group, and a boronic acid group, and more preferably at least one of a carboxyl group and an amino group.

Examples of such a ligand include carboxyl group or amino group-containing compounds, and one of them may be used singly or two or more may be used in combination.

Examples of the carboxyl group-containing compounds include linear or branched aliphatic carboxylic acids having 1 to 30 carbon atoms.

Specific examples of such carboxyl group-containing compounds include arachidonic acid, crotonic acid, trans-2-decenoic acid, erucic acid, 3-decenoic acid, cis-4,7,10,13,16,19-docosahexaenoic acid, 4-decenoic acid, all cis-5,8,11,14,17-eicosapentaenoic acid, all cis-8,11,14-eicosatrienoic acid, cis-9-hexadecenoic acid, trans-3-hexenoic acid, trans-2-hexenoic acid, 2-heptenoic acid, 3-heptenoic acid, 2-hexadecenoic acid, linolenic acid, linoleic acid, $\gamma$-linolenic acid, 3-nonenoic acid, 2-nonenoic acid, trans-2-octenoic acid, petroselinic acid, elaidic acid, oleic acid, 3-octenoic acid, trans-2-pentenoic acid, trans-3-pentenoic acid, ricinoleic acid, sorbic acid, 2-tridecenoic acid, cis-15-tetracosenoic acid, 10-undecenoic acid, 2-undecenoic acid, acetic acid, butyric acid, behenic acid, cerotic acid, decanoic acid, arachidic acid, heneicosanoic acid, heptadecanoic acid, heptanoic acid, hexanoic acid, heptacosanoic acid, lauric acid, myristic acid, melissic acid, octacosanoic acid, nonadecanoic acid, nonacosanoic acid, n-octanoic acid, palmitic acid, pentadecanoic acid, propionic acid, pentacosanoic acid, nonanoic acid, stearic acid, lignoceric acid, tricosanoic acid, tridecanoic acid, undecanoic acid, and valeric acid.

Examples of the amino group-containing compounds include linear or branched aliphatic amines having 1 to 30 carbon atoms.

Specific examples of such amino group-containing compounds include 1-aminoheptadecane, 1-aminononadecane, heptadecan-9-amine, stearylamine, oleylamine, 2-n-octyl-1-dodecylamine, allylamine, amylamine, 2-ethoxyethylamine, 3-ethoxypropylamine, isobutylamine, isoamylamine, 3-methoxypropylamine, 2-methoxyethylamine, 2-methylbutylamine, neopentylamine, propylamine, methylamine, ethylamine, butylamine, hexylamine, heptylamine, n-octylamine, 1-aminodecane, nonylamine, 1-aminoundecane, dodecylamine, 1-aminopentadecane, 1-aminotridecane, hexadecylamine, and tetradecylamine.

The silane compound A is a compound having a binding group capable of binding to the surface of the semiconductor nanocrystal particle and a hydrolyzable silyl group, and one or two or more kinds can be used in step S1.

Examples of the binding group include a carboxyl group, an amino group, an ammonium group, a mercapto group, a phosphine group, a phosphine oxide group, a phosphoric acid group, a phosphonic acid group, a phosphinic acid group, a sulfonic acid group, and a boronic acid group. The binding group includes at least one selected from the group consisting of a carboxyl group, a mercapto group, and an amino group. These binding groups have a high affinity for a cation contained in the semiconductor nanocrystal particle.

The hydrolyzable silyl group can easily form a siloxane bond. Examples of the hydrolyzable silyl group include a silanol group and an alkoxysilyl group having 1 to 6 carbon atoms.

The silane compound A is, for example, a compound represented by the following formula (A1).

[chem. 3]

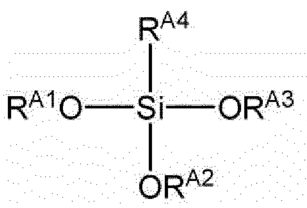

(A1)

In the formula, $R^{A1}$, $R^{A2}$, and $R^{A3}$ each independently represent a hydrogen atom or an alkyl group having 1 to 6 carbon atoms, and $R^{A4}$ represents a monovalent group having the above binding group.

Here, $R^{A1}$, $R^{A2}$, and $R^{A3}$ are each independently preferably an alkyl group having 1 to 3 carbon atoms and

more preferably an alkyl group having 1 to 2 carbon atoms in terms of hydrolysis rate. It is preferable that $R^{A1}$, $R^{A2}$, and $R^{A3}$ have the same carbon number in that equivalent hydrolysis rates are preferable to form a uniform surface layer. Examples of the binding group in $R^{A4}$ include a carboxyl group, an amino group, and a mercapto group.

Specific examples of the silane compound A containing a carboxyl group as the binding group include 3-(trimethoxysilyl) propionic acid, 3-(triethoxysilyl) propionic acid, N-[3-(trimethoxysilyl)propyl]-N'-carboxymethylethylenediamine, N-[3-(trimethoxysilyl)propyl]phthalamide, N-[3-(trimethoxysilyl)propyl]ethylenediamine-N,N',N'-triacetic acid, and 2-(2-oxo-2-((3-(triethoxysilyl)propyl)amino)ethyl)-5-(ethoxysilyl) valeric acid.

Specific examples of the silane compound A containing an amino group as the binding group include 3-aminopropyltrimethoxysilane, 3-aminopropyltriethoxysilane, N-(2-aminoethyl)-3-aminopropyltrimethoxysilane, N-(2-aminoethyl)-3-aminopropyltriethoxysilane, N-(2-aminoethyl)-3-aminopropyltripropoxysilane, N-(2-aminoethyl)-3-aminopropyltriisopropoxysilane, N-(2-aminoethyl)-11-aminoundecyltrimethoxysilane, N-(2-aminoethyl)-3-aminopropylsilanetriol, 3-triethoxysilyl-N-(1,3-dimethylbutylidene)propylamine, N-phenyl-3-aminopropyltrimethoxysilane, N,N-bis[3-(trimethoxysilyl)propyl]ethylenediamine, (aminoethylaminoethyl)phenyltrimethoxysilane, (aminoethylaminoethyl)phenyltriethoxysilane, (aminoethylaminoethyl)phenyltripropoxysilane, (aminoethylaminoethyl)phenyltriisopropoxysilane, (aminoethylaminomethyl)phenyltrimethoxysilane, (aminoethylaminomethyl)phenyltriethoxysilane, (aminoethylaminomethyl)phenyltripropoxysilane, (aminoethylaminomethyl)phenyltriisopropoxysilane, N-(vinylbenzyl)-2-aminoethyl-3-aminopropyltrimethoxysilane, N-β-(N-vinylbenzylaminoethyl-N-γ-(N-vinylbenzyl)-γ-aminopropyltrimethoxysilane, N-β-(N-di(vinylbenzyl)aminoethyl)-γ-aminopropyltrimethoxysilane, N-β-(N-di(vinylbenzyl)aminoethyl)-N-γ-(N-vinylbenzyl)-γ-aminopropyltrimethoxysilane, methylbenzylaminoethylaminopropyltrimethoxysilane, dimethylbenzylaminoethylaminopropyltrimethoxysilane, benzylaminoethylaminopropyltrimethoxysilane, benzylaminoethylaminopropyltriethoxysilane, 3-ureidopropyltriethoxysilane, 3-(N-phenyl)aminopropyltrimethoxysilane, N,N-bis[3-(trimethoxysilyl)propyl] ethylenediamine, (aminoethylaminoethyl)phenethyltrimethoxysilane, (aminoethylaminoethyl)phenethyltriethoxysilane, (aminoethylaminoethyl)phenethyltripropoxysilane, (aminoethylaminoethyl)phenethyltriisopropoxysilane, (aminoethylaminomethyl)phenethyltrimethoxysilane, (aminoethylaminomethyl)phenethyltriethoxysilane, (aminoethylaminomethyl)phenethyltripropoxysilane, (aminoethylaminomethyl)phenethyltriisopropoxysilane, N-[2-[3-(trimethoxysilyl)propylamino]ethyl]ethylenediamine, N-[2-[3-(triethoxysilyl)propylamino]ethyl]ethylenediamine, N-[2-[3-(tripropoxysilyl)propylamino]ethyl]ethylenediamine, and N-[2-[3-(triisopropoxysilyl)propylamino]ethyl]ethylenediamine.

Specific examples of the silane compound A containing a mercapto group as the binding group include 3-mercaptopropyltrimethoxysilane, 3-mercaptopropyltriethoxysilane, 2-mercaptoethyltrimethoxysilane, and 2-mercaptoethyltriethoxysilane.

«Step S2»

In step S2, for example, a polymer solution in which a polymer B containing a first structural unit having a basic group and a second structural unit having no basic group and being solvophilic is dissolved in a solvent such as toluene is added to the solid matter containing the precursor particles. As a result, a state in which the first structural unit having a basic group in the polymer B gathers toward the precursor particle is formed on the surface of the precursor particle.

Specifically, for example, the polymer B is first added to a solvent in a concentration of 0.1 to 100 mg/mL and dissolved at a temperature of 20 to 80°C. Then, for example, 10 to 1000 parts by mass of the polymer solution is added to 1 part by mass of the solid matter containing the precursor particles and stirred for 1 to 60 minutes. After the resulting solution is centrifuged, for example, at 3000 to 10000 rpm for 1 to 30 minutes, the supernatant (e.g., 70 to 100% by volume of the supernatant in the total amount of the solution) is collected to obtain a dispersion liquid containing the precursor particles and a polymer.

The polymer B used in step S2 is an amphiphilic compound and is a polymer containing a first structural unit having a basic group and a second structural unit having no basic group and being solvophilic with an excellent affinity for a dispersion medium. As used herein the dispersion medium is a dispersion medium contained in the light-emitting particle dispersion. The dispersion medium may be a solvent used in step S2 or may be another solvent or a resin such as a photopolymerizable compound.

The polymer B has a first structural unit having a basic group and a second structural unit that is solvophilic.

As the first structural unit having a basic group, it is more preferable to have structural units represented by the following formulas (B1-1) and (B1-2) in terms of adsorption on the semiconductor nanocrystal particle.

[chem. 4]

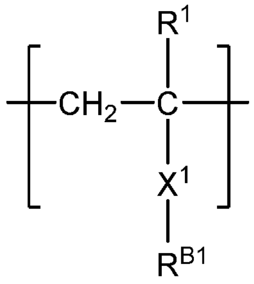

(B1-1)

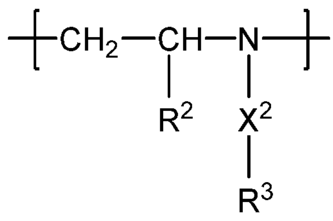

(B1-2)

In the formula, $R^1$, $R^2$, and $R^3$ each independently represent a hydrogen atom or a methyl group, $R^{B1}$ represents a monovalent group having basicity, for example, a basic group including a primary amino group, a secondary amino group, a tertiary amino group, a quaternary ammonium group, an imino group, a pyridyl group, a pyrimidine group, a piperazinyl group, a piperidyl group, an imidazolyl group, a pyrrolidinyl group, and an imidazolidinyl group, and
$X^1$ and $X^2$ each independently represent -COO-, -OCO-, an alkyl chain having 1 to 8 carbon atoms, optionally substituted with a nitrogen atom, or a single bond.

Specific examples of a compound that provides the first structural unit represented by the above formula (B1-1) include 2-vinylpyridine, 4-vinylpyridine, 4-aminostyrene, 4-dimethylaminostyrene, 1-vinylimidazole, dimethylaminoethyl (meth)acrylate, dimethylaminopropyl (meth)acrylate, dimethylaminobutyl (meth)acrylate, diethylaminoethyl (meth)acrylate, diethylaminopropyl (meth)acrylate, dimethylaminopropylacrylamide, diethylaminopropylacrylamide, and allylamine. In the present description, "(meth)acrylate" means one or both of methacrylate and acrylate.

Examples of a compound that provides the first structural unit represented by the above formula (B1-2) include ethyleneimine and propyleneimine.

As the solvophilic second structural unit, it is more preferable to have structural units represented by the following formulas (B2-1) and (B2-2) in terms of dispersibility to the semiconductor nanocrystal particle.

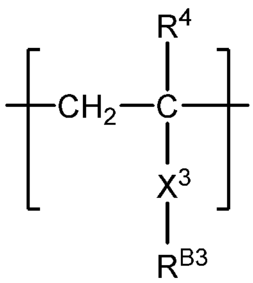

(B2-1)

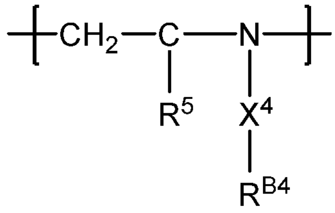

(B2-2)

In the formula, $R^4$ and $R^5$ represent a hydrogen atom or a methyl group, $R^{B3}$ represents a linear or branched alkyl group having 2 to 15 carbon atoms, a cycloalkyl group having 4 to 20 carbon atoms, optionally having a substituent, a polyalkylene oxide group having 10 to 50 carbon atoms with a hydroxy group or an alkoxy group at an end, an aromatic group optionally having a substituent, or a group represented by the general formula (B3),

$X^3$ and $X^4$ represent -COO-, -OCO-, an alkyl chain having 1 to 8 carbon atoms, or a single bond,

$R^{B4}$ represents a group represented by the general formula (B3),

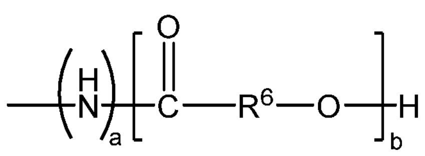

(B3)

$R^6$ represents a linear or branched, saturated or unsaturated divalent hydrocarbon group having 1 to 20 carbons, where a represents 0 or 1, and b represents 1 to 100.

The polyester skeleton in the general formula (B3) is obtained by hydroxycarboxylic acid, self-condensation of

lactone, or mixed condensation of hydroxycarboxylic acid and lactone. Examples of the hydroxycarboxylic acid include 12-hydroxystearic acid, and examples of the lactone include ε-caprolactone, β-propiolactone, γ-butyrolactone, and δ-valerolactone. It is preferable to have at least one structural unit derived from 12-hydroxystearic acid, valerolactone, or caprolactone.

Examples of a compound that provides the second structural unit represented by the above formula (B2-1) include alkyl (meth)acrylates such as methyl (meth)acrylate, ethyl (meth) acrylate, n-butyl (meth)acrylate, sec-butyl (meth)acrylate, tert-butyl (meth)acrylate, isopropyl (meth) acrylate, isobutyl (meth)acrylate, 2-ethylhexyl (meth)acrylate, decyl (meth)acrylate, undecyl (meth)acrylate, dodecyl (meth)acrylate, tridecyl (meth)acrylate, pentadecyl (meth)acrylate, hexadecyl (meth)acrylate, heptadecyl (meth)acrylate, octadecyl (meth)acrylate, nonadecyl (meth)acrylate, and icosanyl (meth)acrylate; aromatic (meth)acrylates such as benzyl (meth)acrylate and phenylethyl (meth)acrylate, (meth)acrylates having an alicyclic structure such as cyclohexyl (meth)acrylate and isobornyl (meth)acrylate; polyalkylene glycol (meth)acrylates having an alkyl group at an end, such as methoxy polyethylene glycol (meth)acrylate, methoxy polypropylene glycol (meth)acrylate, octoxy polyethylene glycol (meth)acrylate, octoxypolypropylene glycol (meth)acrylate, lauroxypolypropylene glycol (meth)acrylate, lauroxypolypropylene glycol (meth)acrylate, stearoxypolyethylene glycol, stearoxypolypropylene glycol (meth)acrylate, aryloxy polyethylene glycol (meth)acrylate, aryloxy polypropylene glycol (meth)acrylate, nonylphenoxy polyethylene glycol (meth)acrylate, and nonylphenoxy polypropylene glycol (meth)acrylate; (meth)acrylate compounds such as glycidyl (meth)acrylate, dicyclopentenyl (meth)acrylate, and tricyclodecanyl (meth)acrylate; styrene derivative monomers such as styrene, α-methylstyrene, 4-tert-butylstyrene, 2,5-dimethylstyrene, and p-isobutylstyrene, and condensates of allylamine and polyester.

Examples of a compound that provides the second structural unit represented by the above formula (B2-2) include condensates of ethyleneimine and polyester and condensates of propyleneimine and polyester.

In the polymer B, the structural units represented by the formula (B1) and the formula (B2) can be used singly or can be used in combination of two or more. Furthermore, the polymer B may be a block copolymer having the first structural unit represented by the formula (B1) as a first polymer block and the second structural unit represented by the formula (B2) as a second polymer block, may be a random polymer having the first structural unit represented by the formula (B1) and the second structural unit represented by the formula (B2) randomly, or may be a graft polymer having the first structural unit represented by the formula (B1) and the second structural unit represented by the formula (B2). In terms of adsorption on the surface of the solid matter containing the precursor particles obtained in step S1, it is preferable that the polymer B is a block copolymer or a graft polymer.

The amount of the first structural unit contained in the polymer B is, for example, preferably 3 mol% or more, 4 mol% or more, or 5 mol% or more, and preferably 50 mol% or less, 30 mol% or less, or 20 mol% or less, with respect to the total structural units constituting the polymer B.

The amount of the second structural unit contained in the polymer B is, for example, preferably 70 mol% or more, 75 mol% or more, or 80 mol% or more, and preferably 97 mol% or less, 96 mol% or less, or 95 mol% or less, with respect to the total structural units constituting the polymer B.

The polymer B may contain other structural units in addition to the first structural unit and the second structural unit. In this case, the total amount of the first structural unit and the second structural unit contained in the polymer B is, for example, preferably 70 mol% or more, 80 mol% or more, or 90 mol% or more, with respect to the total structural units constituting the polymer B.

For example, the polymer B may include a structural unit having an acidic group in addition to the first structural unit and the second structural unit.

Examples of the acidic group include a carboxyl group (-COOH), a sulfo group ($-SO_3H$), a sulfate group ($-OSO_3H$), a phosphonic acid group ($-PO(OH)_3$), a phosphoric acid group ($-OPO(OH)_3$), a phosphinic acid group (-PO(OH)-), and a mercapto group (-SH).

Examples of a nonionic functional group include a hydroxy group, an ether group, a thioether group, a sulfinyl group (-SO-), a sulfonyl group ($-SO_2-$), a carbonyl group, a formyl group, an ester group, a carbonate ester group, an amide group, a carbamoyl group, a ureido group, a thioamide group, a thioureido group, a sulfamoyl group, a cyano group, an alkenyl group, an alkynyl group, a phosphine oxide group, and a phosphine sulfide group.

Examples of a compound that provides the structural unit having an acidic group include a (meth)acrylate having a carboxy group, a (meth)acrylate having a phosphoric acid group, and a (meth)acrylate having a sulfone group. Examples of the (meth)acrylate having a carboxy group include monomers and (meth)acrylic acid in which a (meth)acrylate having a hydroxy group, such as carboxyethyl (meth)acrylate, carboxypentyl (meth)acrylate, 2-(meth)acryloyloxyethyl succinate, 2-(meth)acryloyloxyethyl maleate, and 2-(meth)acryloyloxyethyl phthalate, is reacted with an acid anhydride such as maleic anhydride, succinic anhydride, and phthalic anhydride. Examples of the (meth)acrylate having a sulfonic acid group include ethyl (meth)acrylate sulfonate. Examples of the (meth)acrylate having a phosphoric acid group include 2-(phosphonooxy)ethyl (meth)acrylate.

The weight average molecular weight (Mw) in the polymer B is measured by gel permeation chromatography (GPC) and expressed in terms of standard polystyrene. In terms of dispersibility of light-emitting particles, a range of

3,000 or more to 200,000 or less is preferred, a range of 4,000 or more to 100,000 or less is more preferred, and a range of 5,000 or more to 80,000 or less is even more preferred. The measurement conditions are the same as in the examples in the present description.

«Step S3»

In step S3, for example, the polymer solution containing the precursor particles, the polymer B, and the solvent obtained in step S2 is mixed with a solution containing a silane compound C. The hydrolyzable silyl group of the silane compound C condenses to form a siloxane bond, whereby a layer containing the polymer B and a polymer of the silane compound C is formed on the surface of the precursor particle. As a result, a light-emitting particle having a surface layer containing Si is formed on the surface of the semiconductor nanocrystal particle. The surface layer contains polysiloxane derived from the silane compound A, the polymer B, and polysiloxane derived from the silane compound C. Subsequently, the resulting reaction solution is centrifuged and the supernatant is collected to obtain a light-emitting particle dispersion in which the light-emitting particles are dispersed in the solvent.

Specifically, for example, a solution containing the silane compound C is added to the polymer solution such that the amount of the silane compound C is, for example, 0.1 to 50 parts by mass with respect to 1 part by mass of the precursor particles in the polymer solution obtained in step S2, and the solution is stirred for 5 to 300 minutes.

After mixing the polymer solution and the solution containing the silane compound C, water (e.g., ion-exchanged water) may be further added in terms of hydrolysis control. The amount of water added may be, for example, 1 to 100 parts by mass with respect to 100 parts by mass of the silane compound C. After adding water, the solution is stirred, for example, for 5 to 300 minutes.

Then, the resulting reaction solution is centrifuged, for example, at 3000 to 15000 rpm for 1 to 30 minutes, and then the supernatant (e.g., 70 to 100% by volume of the supernatant in the total reaction solution) can be collected to obtain a light-emitting particle dispersion in which the light-emitting particles are dispersed in the solvent.

The silane compound C used in step S3 is preferably, for example, a compound represented by the following formula (C1) .

[chem. 5]

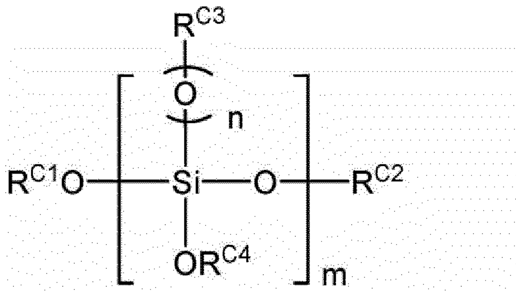

(C1)

In the formula, $R^{C1}$ and $R^{C2}$ each independently represent an alkyl group, $R^{C3}$ and $R^{C4}$ each independently represent a hydrogen atom or an alkyl group, n represents 0 or 1, and m represents an integer of 1 or more. It is preferable that m is an integer of 10 or less.

Specific examples of the compound represented by the formula (C1) include tetrabutoxysilane, tetrapropoxysilane, tetraisopropoxysilane, tetramethoxysilane, tetraethoxysilane, methyltrimethoxysilane, methyltriethoxysilane, ethyltrimethoxysilane, phenyltrimethoxysilane, vinyltriethoxysilane, n-propyltrimethoxysilane, isopropyltrimethoxysilane, n-butyltriethoxysilane, n-hexyltrimethoxysilane, n-hexyltriethoxysilane, n-octyltrimethoxysilane, n-octyltriethoxysilane, n-decyltrimethoxysilane, n-dodecyltrimethoxysilane, n-dodecyltriethoxysilane, n-hexadecyltrimethoxysilane, n-hexadecyltriethoxysilane, n-octadecyltrimethoxysilane, trimethoxy(3,3,3-trifluoropropyl)silane, trimethoxy(pentafluorophenyl)silane, trimethoxy(11-pentafluorophenoxyundecyl) silane, trimethoxy(1H,1H,2H,2H-nonafluorohexyl)silane, partially hydrolyzed oligomer of tetramethoxysilane (product names: methylsilicate 51, methylsilicate 53A (available from COLCOAT CO.,LTD.)), partially hydrolyzed oligomer of tetraethoxysilane (product names: ethylsilicate 40, ethylsilicate 48 (available from COLCOAT CO.,LTD.)), partially hydrolyzed oligomer of tetramethoxysilane and tetraethoxysilane mixture (product names: EMS-485 (available from COLCOAT CO.,LTD.)).

In addition to the compound represented by the above formula (C1), for example, a compound represented by the following formula (C2) and a compound reprsented by (C3) can be used in combination as the silane compound C.

[chem. 6]

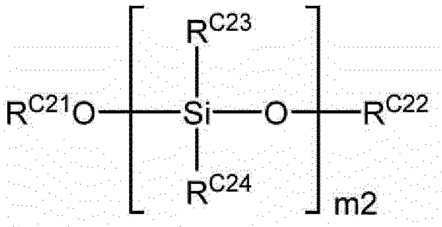

(C2)

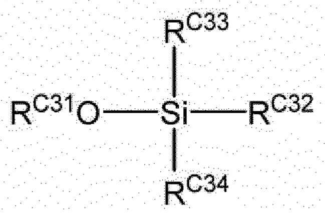

(C3)

In the formula, $R^{C21}$, $R^{C22}$, and $R^{C31}$ each independently represent an alkyl group, and $R^{C23}$, $R^{C24}$, $R^{C32}$, $R^{C33}$, and $R^{C34}$ each independently represent a hydrogen atom, an alkyl group optionally having a substituent, a phenyl group, or a cyclohexyl group, the carbon atom in the alkyl group may be substituted with an oxygen atom or a nitrogen atom, and m2 represents an integer of 1 or more and 10 or less.

Specific examples of the compound represented by the formula (C2) and the compound represented by the formula (C3) include dimethyldiethoxysilane, diphenyldimethoxysilane, methyl ethyl dimethoxysilane, and trimethyl methoxysilane. One of the compounds represented by the formula (C1) can be used singly or two or more may be used in combination. One or two or more of the compounds represented by the formula (C2) and the compounds represented by (C3) can be used in combination with the compound represented by the general formula (C1).

In the light-emitting particle dispersion obtained by the production method of the present embodiment, the surface layer containing Si of the light-emitting particle dispersed in the solvent contains polysiloxane attributable to the silane compound A, the polymer B, and polysiloxane attributable to the silane compound C. The polysiloxane attributable to the silane compound A is presumably unevenly distributed on the semiconductor nanoparticle side because it is bonded (coordinated) to the semiconductor nanocrystal particle by the binding group. On the surface side of the polysiloxane attributable to A, the polymer B gathers such that the basic group in the first structural unit is located on the semiconductor nanocrystal particle side. In the polymer B, the basic group in the first structural unit may be bonded (coordinated) to the semiconductor nanocrystal particle or may be bonded (coordinated) to the polysiloxane attributable to the silane compound A. The polysiloxane attributable to the silane compound C is presumably unevenly distributed outside of the polysiloxane attributable to the silane compound A in the surface layer. The polysiloxane attributable to the silane compound C may be coordinated (bonded) to the basic group in the first structural unit of the polymer B. The polysiloxane attributable to the silane compound C is presumably formed on the surface of the particle using the first structural unit having a basic group of the polymer B as a template. According to the foregoing, since the light-emitting particle surface is tightly coated with the layer having Si, the light-emitting particle dispersion can ensure excellent stability against oxygen, heat, and polar solvents such as water. Furthermore, since the basic group in the first structural unit of the polymer B is positioned on the semiconductor nanocrystal particle side, the solvophilic second structural unit is positioned on the surface outside of the light-emitting particle. Therefore, high dispersibility in the dispersion medium in the light-emitting particle dispersion can be imparted to the light-emitting particles in the light-emitting particle dispersion. As described above, according to the production method of the present embodiment, a light-emitting particle dispersion with excellent dispersibility and stability can be obtained.

The thickness of the surface layer is, for example, preferably 1 nm or more, 2 nm or more, or 3 nm or more, and preferably 200 nm or less, 100 nm or less, or 50 nm or less. The light-emitting particle having the surface layer with such a thickness provides excellent stability and excellent dispersibility in a dispersion medium.

The average particle size (volume average diameter) of the light-emitting particles is, for example, preferably 10 nm or more, 15 nm or more, or 20 nm or more, and preferably 400 nm or less, 300 nm or less, or 200 nm or less. The average particle size of the light-emitting particles means the volume average diameter as measured by dynamic light scattering.

<Light-Emitting Particle Dispersion>

It is preferable that the light-emitting particles of the present invention are dispersed in a dispersion medium and used as a light-emitting particle dispersion. It is preferable that a solvent or a photopolymerizable compound is used as the dispersion medium. It is preferable that the light-emitting particle dispersion contains at least a photopolymerizable compound as the dispersion medium and further contains a photopolymerizable compound. Such a light-emitting particle dispersion is particularly suitable as a coating composition for light conversion films or an ink composition for UV-curable inkjet printing. In this case, the solvent may or may not be contained. A light-emitting dispersion containing light-emitting particles, a photopolymerizable compound, and a photopolymerizable compound (hereinafter referred to as "ink composition") will be described below.

The detail of the light-emitting particles is as described above. The amount of the light-emitting particles contained in the ink composition is preferably 10% by mass or more, 15% by mass or more, or 20% by mass or more, and preferably 50% by mass or less, 45% by mass or less, or 40% by mass or less. With the amount of light-emitting particles set in the above range, the discharge stability can be further improved when the ink composition is ejected by an inkjet printing method. In addition, the light-emitting particles are less likely to aggregate, and the external quantum efficiency of the resulting light-emitting layer (light conversion layer) can be enhanced.

<<Photopolymerizable Compound>>

The photopolymerizable compound is preferably a photoradical polymerizable compound that polymerizes upon irradiation of light and may be a photopolymerizable monomer or oligomer. These are used together with a photopolymerization initiator. The photopolymerizable compounds may be used singly or may be used in combination of two or more.

Examples of the photoradical polymerizable compound include (meth)acrylate compounds. The (meth)acrylate compounds may be a monofunctional (meth)acrylate having one (meth)acryloyl group or may be a multifunctional (meth)acrylate having a plurality of (meth)acryloyl groups. It is preferable to use a monofunctional (meth)acrylate and a multifunctional (meth)acrylate in combination in terms of excellent fluidity when the ink composition is prepared, excellent discharge stability, and suppressing deterioration in smoothness due to curing shrinkage during production of a coating film containing light-emitting particles.

Examples of the monofunctional (meth)acrylate include methyl (meth)acrylate, ethyl (meth)acrylate, propyl (meth)acrylate, butyl (meth)acrylate, amyl (meth)acrylate, 2-ethylhexyl (meth)acrylate, octyl (meth)acrylate, nonyl (meth)acrylate, dodecyl (meth)acrylate, hexadecyl (meth)acrylate, octadecyl (meth)acrylate, cyclohexyl (meth)acrylate, methoxyethyl (meth)acrylate, butoxyethyl (meth)acrylate, phenoxyethyl (meth)acrylate, nonylphenoxyethyl (meth)acrylate, glycidyl (meth)acrylate, dimethylaminoethyl (meth)acrylate, diethylaminoethyl (meth)acrylate, isobornyl (meth)acrylate, dicyclopentanyl (meth)acrylate, dicyclopentenyl (meth)acrylate, dicyclopentenyloxyethyl (meth)acrylate, 2-hydroxy-3-phenoxypropyl (meth)acrylate, tetrahydrofurfuryl (meth)acrylate, 2-hydroxyethyl (meth)acrylate, benzyl (meth)acrylate, phenylbenzyl (meth)acrylate, mono(2-acryloyloxyethyl) succinate, N-[2-(acryloyloxy)ethyl] phthalimide, and N-[2-(acryloyloxy)ethyl] tetrahydrophthalimide.

The polyfunctional (meth)acrylate may be a bifunctional (meth)acrylate, a trifunctional (meth)acrylate, a tetrafunctional (meth)acrylate, a pentafunctional (meth)acrylate, a hexafunctional (meth)acrylate, or the like, and may be, for example, di(meth)acrylate in which two hydroxyl groups of a diol compound are substituted with (meth)acryloyloxy group, di or tri(meth)acrylate in which two or three hydroxyl groups of a triol compound are substituted with (meth)acryloyloxy group, or the like.

Specific examples of the bifunctional (meth)acrylate include, for example, 1,3-butylene glycol di(meth)acrylate, 1,4-butanediol di(meth)acrylate, 1,5-pentanediol di(meth)acrylate, 3-methyl-1,5-pentanediol di(meth)acrylate, 1,6-hexanediol di(meth)acrylate, neopentyl glycol di(meth)acrylate, 1,8-octanediol di(meth)acrylate, 1,9-nonanediol di(meth)acrylate, tricyclodecanedimethanol di(meth)acrylate, ethylene glycol di(meth)acrylate, polyethylene glycol di(meth)acrylate, propylene glycol di(meth)acrylate, dipropylene glycol di(meth)acrylate, tripropylene glycol di(meth)acrylate, polypropylene glycol di(meth)acrylate, neopentylglycol hydroxypivalic acid ester diacrylate, and di(meth)acrylate in which two hydroxyl groups of tris(2-hydroxyethyl) isocyanurate are substituted with (meth)acryloyloxy group, di(meth)acrylate in which two hydroxyl groups of the diol obtained by adding 4 mol or more of ethylene oxide or propylene oxide to 1 mol of neopentyl glycol are substituted with (meth)acryloyloxy group, di(meth)acrylate in which two hydroxyl groups of the diol obtained by adding 2 mol of ethylene oxide or propylene oxide to 1 mol of bisphenol A are substituted with (meth)acryloyloxy group, di(meth)acrylate in which two hydroxyl groups of the triol obtained by adding 3 mol or more of ethylene oxide or propylene oxide to 1 mol of trimethylolpropane are substituted with (meth)acryloyloxy group, and di(meth)acrylate in which two hydroxyl groups of the diol obtained by adding 4 mol or more of ethylene oxide or propylene oxide to 1 mol of bisphenol A are substituted with (meth)acryloyloxy group.

Specific examples of the trifunctional (meth)acrylate include, for example, trimethylolpropane tri(meth)acrylate,

glycerin triacrylate, pentaerythritol tri(meth)acrylate, and tri(meth)acrylate in which three hydroxyl groups of the triol obtained by adding 3 mol or more of ethylene oxide or propylene oxide to 1 mol of trimethylolpropane are substituted with (meth)acryloyloxy group.

Specific examples of the tetrafunctional (meth)acrylate include pentaerythritol tetra(meth)acrylate.

Specific examples of the pentafunctional (meth)acrylate include dipentaerythritol penta(meth)acrylate.

Specific examples of the hexafunctional (meth)acrylate include dipentaerythritol hexa(meth)acrylate.

The polyfunctional (meth)acrylate may be a poly(meth)acrylate in which a plurality of hydroxyl groups of dipentaerythritol such as dipentaerythritol hexa(meth)acrylate are substituted with (meth)acryloyloxy groups.

The (meth)acrylate compound may be an ethylene oxide-modified phosphoric acid (meth)acrylate, an ethylene oxide-modified alkyl phosphoric acid (meth)acrylate, or the like, which has a phosphoric acid group.

The molecular weight of the photopolymerizable compound may be, for example, 50 or more and may be 100 or more or 150 or more. The molecular weight of the photopolymerizable compound may be, for example, 500 or less and may be 400 or less or 300 or less. When the composition is applied using an inkjet printing method, the molecular weight is preferably 50 to 500 and more preferably 100 to 400, in terms of easily achieving both viscosity and volatilization resistance of the ink after ejection. When the composition is applied to a base such as a film using a printing method such as roll coater, gravure coater, flexo coater, or die coater, the molecular weight is preferably 100 to 500 and more preferably 150 to 400 in terms of easily achieving both viscosity and leveling properties.

In the ink composition, when a curable component is constituted with the photopolymerizable compound alone or as a main component, as the photopolymerizable compound as described above, it is more preferable that a bifunctional or multifunctional photopolymerizable compound having two or more polymerizable functional groups in one molecule is used an essential component, because the durability (strength, heat resistance, etc.) of the cured product can be further enhanced.

The amount of the photopolymerizable compound contained in the ink composition is preferably 40 to 80% by mass, more preferably 45 to 75% by mass, and even more preferably 50 to 70% by mass. When the amount of the photopolymerizable compound contained in the ink composition is set in the above range, the dispersion state of the light-emitting particles in the resulting light-emitting layer (light conversion layer) is satisfactory, and thus the external quantum efficiency can be further enhanced.

<<Photopolymerization Initiator>>

The photopolymerization initiator is preferably at least one selected from the group consisting of alkylphenone compounds, acylphosphine oxide compounds, and oxime ester compounds.

Examples of the alkylphenone-based photopolymerization initiator include compounds represented by the formula (b-1).

[chem. 7]

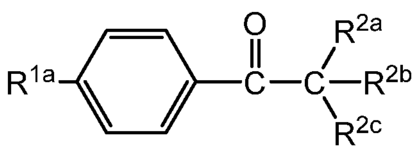

(b-1)

In the formula, R1a represents a group selected from the following formulas ($R^{1a}$-1) to ($R^{1a}$-6), and $R^{2a}$, $R^{2b}$, and $R^{2c}$ each independently represent a group selected from the following formulas ($R^2$-1) to ($R^2$-7).

[chem. 8]

$-H$ $(R^{1a}\text{-}1)$ $-SCH_3$ $(R^{1a}\text{-}2)$ $-O-CH_2CH_2-OH$ $(R^{1a}\text{-}3)$

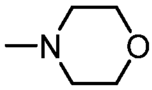

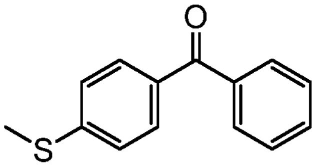

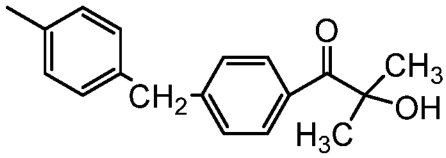

$(R^{1a}\text{-}4)$ $(R^{1a}\text{-}5)$ $(R^{1a}\text{-}6)$

[chem. 9]

$-CH_3$ $(R^2\text{-}1)$ $-CH_2CH_3$ $(R^2\text{-}2)$ $-OH$ $(R^2\text{-}3)$ $-N(CH_3)_2$ $(R^2\text{-}4)$

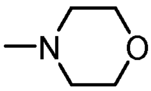

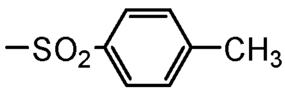

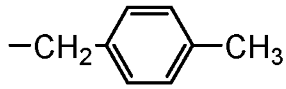

$(R^2\text{-}5)$ $(R^2\text{-}6)$ $(R^2\text{-}7)$

As specific examples of the compounds represented by the above formula (b-1), compounds represented by the following formulas (b-1-1) to (b-1-6) are preferred, and compounds represented by the following formula (b-1-1), (b-1-5), or (b-1-6) are more preferred.

[chem. 10]

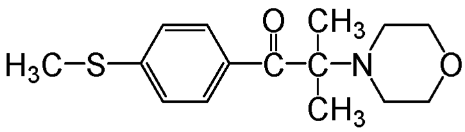

(b-1-1)

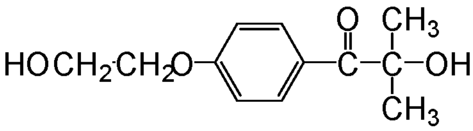

(b-1-2)

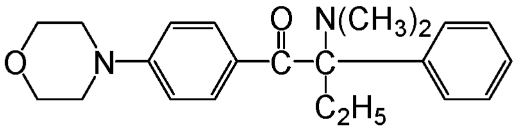

(b-1-3)

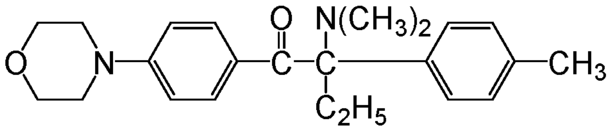

(b-1-4)

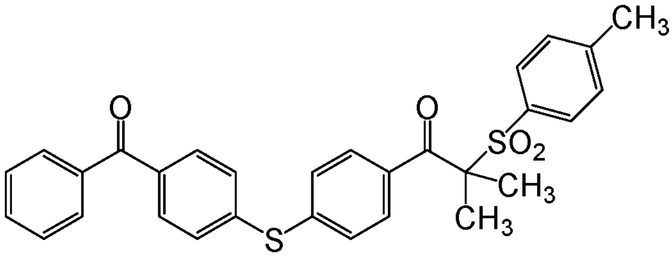

(b-1-5)

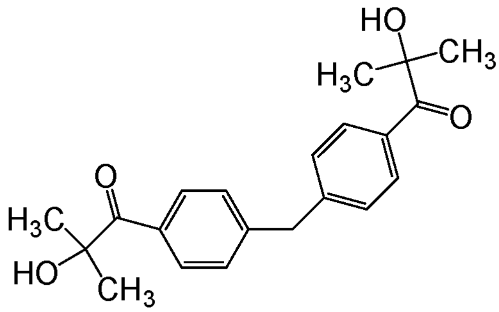

(b-1-6)

Examples of the acylphosphine oxide-based photopolymerization initiator include compounds represented by the formula (b-2).

[chem. 11]

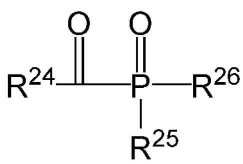

(b-2)

In the formula, $R^{24}$ represents an alkyl group, an aryl group, or a heterocyclic group, and $R^{25}$ and $R^{26}$ each independently represent an alkyl group, an aryl group, a heterocyclic group, or an alkanoyl group, where these groups may be substituted with an alkyl group, a hydroxyl group, a carboxyl group, a sulfone group, an aryl group, an alkoxy group, or an arylthio group.

As specific examples of the compounds represented by the above formula (b-2), compounds represented by the following formulas (b-2-1) to (b-2-5) are preferred, and compounds represented by the following formula (b-2-1) or

(b-2-5) are more preferred.

[chem. 12]

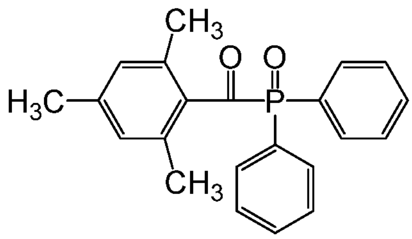

(b-2-1)

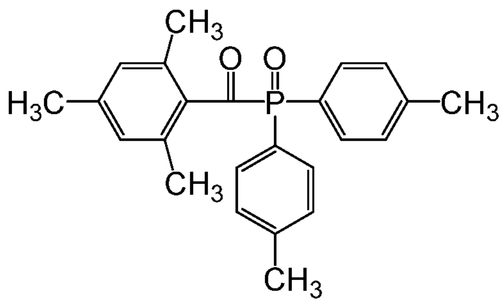

(b-2-2)

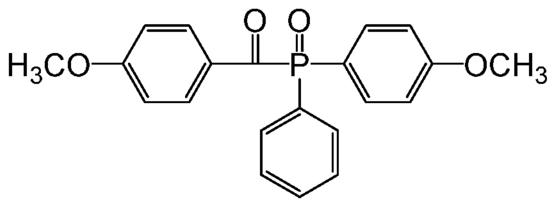

(b-2-3)

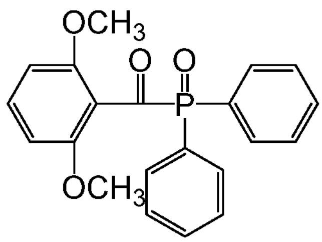

(b-2-4)

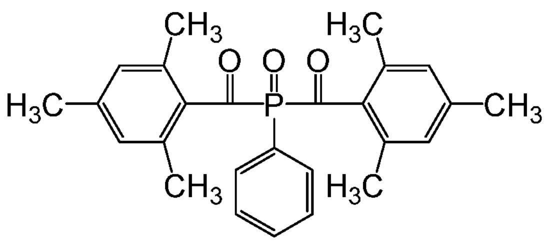

(b-2-5)

Examples of the oxime ester-based photopolymerization initiator include compounds represented by the following formula (b-3-1) or (b-3-2).

[chem. 13]

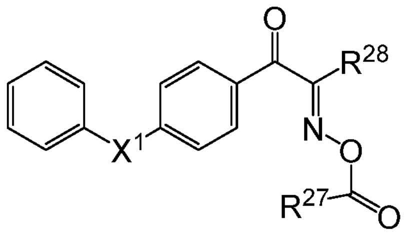

(b-3-1)

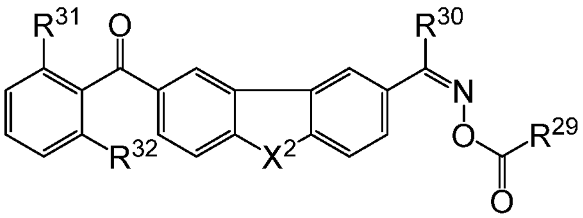

(b-3-2)

In the formula, $R^{27}$ to $R^{31}$ each independently represent a hydrogen atom, a cyclic, linear or branched alkyl group having 1 to 12 carbon atoms, or a phenyl group, where each alkyl group and phenyl group may be substituted with a substituent selected from the group consisting of a halogen atom, an alkoxyl group having 1 to 6 carbon atoms, and a phenyl group, $X^1$ represents an oxygen atom or a nitrogen atom, $X^2$ represents an oxygen atom or NR, where R represents an alkyl group having 1 to 6 carbon atoms.

As specific examples of the compounds represented by the above formulas (b-3-1) and (b-3-2), compounds represented by the following formulas (b-3-1-1) to (b-3-1-2) and the following formulas (b-3-2-1) to (b-3-2-2) are preferred, and compounds represented by the following formula (b-3-1-1), (b-3-2-1), or (b-3-2-2) are more preferred.

[chem. 14]

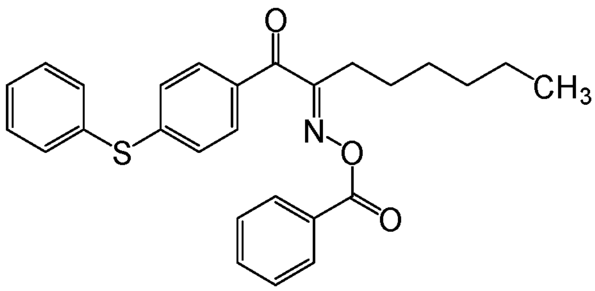

(b-3-1-1)

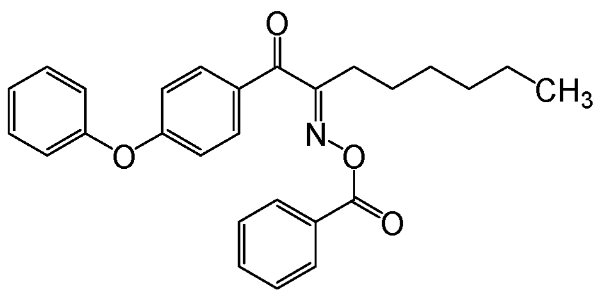

(b-3-1-2)

[chem. 15]

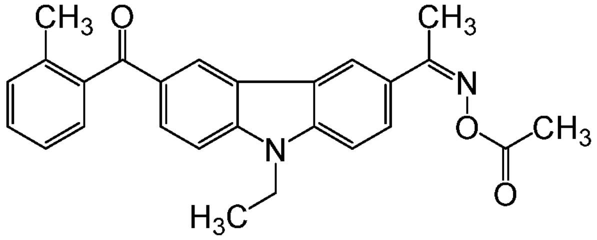

(b-3-2-1)

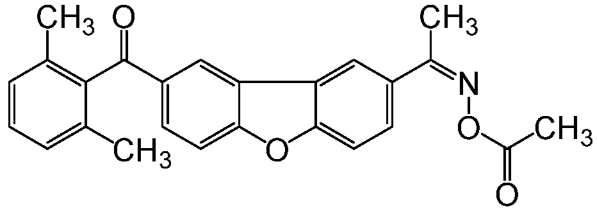

(b-3-2-2)

The amount of the photopolymerization initiator contained is preferably 0.05 to 10% by mass, more preferably 0.1 to 8% by mass, and even more preferably 1 to 6% by mass with respect to the total amount of the photopolymerizable compound contained in the ink composition. The photopolymerization initiators can be used singly or in combination of two or more. The ink composition containing the photopolymerization initiator in such an amount can maintain sufficient photosensitivity during photocuring. In addition, crystals of the photopolymerization initiator are less likely to precipitate when the coating film is dried, and thus deterioration of the coating film properties can be suppressed.

When the photopolymerization initiator is dissolved in the ink composition, it is preferable to dissolve it in the photopolymerizable compound in advance before use.

To dissolve the photopolymerization initiator in the photopolymerizable compound, it is preferable to dissolve it uniformly by adding the photopolymerization initiator while stirring the photopolymerizable compound so that a reaction by heat is not started.

The dissolution temperature of the photopolymerization initiator may be adjusted as appropriate considering the solubility of the photopolymerization initiator used in the photopolymerizable compound and the thermal polymerizable property of the photopolymerizable compound, but preferably 10 to 50°C, more preferably 10 to 40°C, and even more preferably 10 to 30°C in term of preventing start of polymerization of the photopolymerizable compound.

The ink composition may contain components other than the light-emitting particles, the photopolymerizable compound, and the photopolymerization initiator as long as the effects of the present invention are not impaired. Examples of such other components include polymerization inhibitors, antioxidants, dispersants, leveling agents, chain transfer agents, dispersion aids, thermoplastic resins, sensitizers, and light-scattering particles.

<<Polymerization Inhibitor>>

Examples of the polymerization inhibitor include phenolic compounds such as p-methoxyphenol, cresol, t-butylcatechol, 3,5-di-t-butyl-4-hydroxytoluene, 2,2'-methylene bis(4-methyl-6-t-butylphenol), 2,2'-methylene bis(4-ethyl-6-t-butylphenol), 4,4'-thiobis(3-methyl-6-t-butylphenol), 4-methoxy-1-naphthol, and 4,4'-dialkoxy-2,2'-bi-1-naphthol; quinone compounds such as hydroquinone, methylhydroquinone, tert-butylhydroquinone, p-benzoquinone, methyl-p-benzoquinone, tert-butyl-p-benzoquinone, 2,5-diphenylbenzoquinone, 2-hydroxy-1,4-naphthoquinone, 1,4-naphthoquinone, 2,3-dichloro-1,4-naphthoquinone, anthraquinone, and diphenoquinone; amine-based compounds such as p-phenylenediamine, 4-aminodiphenylamine, N,N'-diphenyl-p-phenylenediamine, N-i-propyl-N'-phenyl-p-phenylenediamine, N-(1.3-dimethylbutyl)-N'-phenyl-p-phenylenediamine, N,N'-di-2-naphthyl-p-phenylenediamine, diphenylamine, N-phenyl-β-naphthylamine, 4,4'-dicumyl-diphenylamine, and 4,4'-dioctyl-diphenylamine; thioether-based compounds such as phenothiazine and distearylthiodipropionate; N-oxyl compounds such as 2,2,6,6-tetramethylpiperidine-1-oxyl free radical, 2,2,6,6-tetramethylpiperidine, and 4-hydroxy-2,2,6,6-tetramethylpiperidin-1-oxyl free radical; nitroso compounds such as N-nitrosodiphenylamine, N-nitrosophenylnaphthylamine, N-nitrosodinaphthylamine, p-nitrosophenol, nitrosobenzene, p-nitrosodiphenylamine, α-nitroso-β-naphthol, N,N-dimethyl-p-nitrosoaniline, p-nitrosodiphenylamine, p-nitrosodimethylamine, p-nitroso-N,N-diethylamine, N-nitrosoethanolamine, N-nitroso-di-n-butylamine, N-nitroso-N-n-butyl-4-butanolamine, N-nitroso-diisopropanolamine, N-nitroso-N-ethyl-4-butanolamine, 5-nitroso-8-hydroxyquinoline, N-nitrosomorpholin, N-nitroso-N-phenylhydroxylamine ammonium salt (available from Fuji Film Wako Pure Chemical Industries, Ltd., "Q-1300"), nitroso benzene, 2,4,6-tri-tert-butylnitrobenzene, N-nitroso-N-methyl-p-toluenesulfonamide,

N-nitroso-N-ethylurethane, N-nitroso-N-n-propylurethane, 1-nitroso-2-naphthol, 2-nitroso-1-naphthol, sodium 1-nitroso-2-naphthol-3,6-sulfonate, sodium 2-nitroso-1-naphthol-4-sulfonate, 2-nitroso-5-methylaminophenol hydrochloride, 2-nitroso-5-methylaminophenol hydrochloride, and Q-1301 (available from Fuji Film Wako Pure Chemical Industries, Ltd.).

The amount of the polymerization inhibitor added is preferably 0.01 to 1.0% by mass and more preferably 0.02 to 0.5% by mass with respect to the total amount of the photopolymerizable compound contained in the ink composition.

<<Antioxidant>>

Examples of the antioxidant include pentaerythritol tetrakis[3-(3,5-di-tert-butyl-4-hydroxyphenyl) propionate ("IRGANOX1010"), thiodiethylenebis[3-(3,5-di-tert-butyl-4-hydroxyphenyl) propionate ("IRGANOX1035"), octadecyl-3-(3,5-di-tert-butyl-4-hydroxyphenyl) propionate ("IRGANOX1076"), "IRGANOX1135", "IRGANOX1330", 4,6-bis(octylthiomethyl)-o-cresol ("IRGANOX1520L"), "IRGANOX1726", "IRGANOX245", "IRGANOX259", "IRGANOX3114", "IRGANOX3790", "IRGANOX5057", and "IRGANOX565" (all above available from BASF SE, IRGANOX is a registered trademark); "ADK STAB AO-20", "ADK STAB AO-30", "ADK STAB AO-40", "ADK STAB AO-50", "ADK STAB AO-60", and "ADK STAB AO-80" (all above available from ADEKA Co., Ltd., ADK STAB is a registered trademark); "JP-360", "JP-308E", "JPE-10" (all above available from Johoku Chemical Co., Ltd.); "SUMILIZER BHT", "SUMILIZER BBM-S", and "SUMILIZER GA-80" (all above available from SUMITOMO CHEMICAL COMPANY, LIMITED, SUMILIZER is a registered trademark).

The amount of the antioxidant added is preferably 0.01 to 2.0% by mass and more preferably 0.02 to 1.0% by mass with respect to the total amount of the photopolymerizable compound contained in the ink composition.

<<Dispersant>>

The dispersant is any compound that can improve the dispersion stability of the light-emitting particles in the ink composition. Dispersants are classified into low-molecular weight dispersants and high-molecular weight dispersants.

In the present description, "low-molecular" means a molecule with a weight average molecular weight (Mw) of 5,000 or less, and "high-molecular" means a molecule with a weight average molecular weight (Mw) of more than 5,000. In the present description, the value measured by gel permeation chromatography (GPC) using polystyrene as a standard material can be employed as "weight average molecular weight (Mw)".

Examples of the low-molecular weight dispersants include oleic acid; phosphorous atom-containing compounds such as triethyl phosphate, TOP (trioctylphosphine), TOPO (trioctylphosphine oxide), hexylphosphonic acid (HPA), tetradecylphosphonic acid (TDPA), and octylphosphinic acid (OPA); nitrogen atom-containing compounds such as oleylamine, octylamine, trioctylamine, and hexadecylamine; sulfur atom-containing compounds such as 1-decanethiol, octanethiol, dodecanethiol, and amylsulfide.

On the other hand, examples of the high-molecular dispersants include acrylic resins, polyester resins, polyurethane resins, polyamide resins, polyether resins, phenol resins, silicone resins, polyurea resins, amino resins, polyamine resins (polyethyleneimine, polyallylamine, and the like), epoxy resins, polyimide resins, natural rosins such as wood rosins, gum rosins, and tall oil rosin, modified rosins such as polymerized rosins, disproportionated rosins, hydrogenated rosins, oxide rosins, and maleinized rosins, rosin amines, lime rosins, rosin alkylene oxide adducts, rosin alkyd adducts, and rosin derivatives such as rosin modified phenols.

As commercially available high-molecular dispersants, for example, Disperbyk (registered trademark) series from BYK-Chemie GmbH, TEGO (registered trademark) Dispers series from Evonik, EFKA (registered trademark) series from BASF SE, SOLSPERSE (registered trademark) series from Lubrizol Japan Limited, AJISPER (registered trademark) series available from Ajinomoto Fine-Techno Co., Inc., DISPARLON (registered trademark) series from Kusumoto Chemicals, Ltd., FLOWLEN series from Kyoeisha Chemical Co., Ltd., and the like can be used.

The amount of the dispersant blended is preferably 0.05 to 10 parts by mass and more preferably 0.1 to 5 parts by mass with respect to 100 parts by mass of the light-emitting particles.

<<Leveling Agent>>

The leveling agent is not limited but preferably a compound that can reduce film thickness unevenness when a thin film of light-emitting particles is formed.

Examples of such leveling agents include alkyl carboxylates, alkyl phosphates, alkyl sulfonates, fluoroalkyl carboxylates, fluoroalkyl phosphates, fluoroalkyl sulfonates, polyoxyethylene derivatives, fluoroalkyl ethylene oxide derivatives, polyethylene glycol derivatives, alkylammonium salts, and fluoroalkylammonium salts.

Specific examples of the leveling agent include "MEGAFACE F-114", "MEGAFACE F-251", "MEGAFACE F-281", "MEGAFACE F-410", "MEGAFACE F-430", "MEGAFACE F-444", "MEGAFACE F-472SF", "MEGAFACE F-477", "MEGAFACE F-510", "MEGAFACE F-511", "MEGAFACE F-552", "MEGAFACE F-553", "MEGAFACE F-554", "MEGAFACE F-555", "MEGAFACE F-556", "MEGAFACE F-557", "MEGAFACE F-558", "MEGAFACE F-559", "MEGAFACE F-560", "MEGAFACE F-561", "MEGAFACE F-562", "MEGAFACE F-563", "MEGAFACE F-565", "MEGAFACE F-567", "MEGAFACE F-568", "MEGAFACE F-569", "MEGAFACE F-570", "MEGAFACE F-571", "MEGAFACE R-40", "MEGAFACE R-41", "MEGAFACE R-43", "MEGAFACE R-94", "MEGAFACE RS-72-K", "MEGAFACE RS-75", "MEGAFACE RS-76-E", "MEGAFACE RS-76-NS", "MEGAFACE RS-90", "MEGAFACE EXP.TF-1367", "MEGAFACE EXP.TF1437", "MEGAFACE EXP.TF1537", and "MEGAFACE EXP.TF-2066" (all above available from DIC Corporation, MEGAFACE is a registered trademark).

Other specific examples of the leveling agent include "FTERGENT 100", "FTERGENT 100C", "FTERGENT 110", "FTERGENT 150", "FTERGENT 150CH", "FTERGENT 100A-K", "FTERGENT 300", "FTERGENT 310", "FTERGENT 320", "FTERGENT 400SW", "FTERGENT 251", "FTERGENT 215M", "FTERGENT 212M", "FTERGENT 215M", "FTERGENT 250", "FTERGENT 222F", "FTERGENT 212D", "FTX-218", "FTERGENT 209F", "FTERGENT 245F", "FTERGENT 208G", "FTERGENT 240G", "FTERGENT 212P", "FTERGENT 220P", "FTERGENT 228P", "DFX-18", "FTERGENT 601AD", "FTERGENT 602A", "FTERGENT 650A", "FTERGENT 750FM", "FTX-730FM", "FTERGENT 730FL", "FTERGENT 710FS", "FTERGENT 710FM", "FTERGENT 710FL", "FTERGENT 750LL", "FTX-730LS", and "FTERGENT 730LM" (all above available from NEOS COMPANY LIMITED).

Other specific examples of the leveling agent include "BYK-300", "BYK-302", "BYK-306", "BYK-307", "BYK-310", "BYK-315", "BYK-320", "BYK-322", "BYK-323", "BYK-325", "BYK-330", "BYK-331", "BYK-333", "BYK-337", "BYK-340", "BYK-344", "BYK-370", "BYK-375", "BYK-377", "BYK-350", "BYK-352", "BYK-354", "BYK-355", "BYK-356", "BYK-358N", "BYK-361N", "BYK-357", "BYK-390", "BYK-392", "BYK-UV3500", "BYK-UV3510", "BYK-UV3570", and "BYK-Silclean3700" (all above available from BYK-Chemie GmbH).

Other specific examples of the leveling agent include "TEGO Rad2100", "TEGO Rad2011", "TEGO Rad2200N", "TEGO Rad2250", "TEGO Rad2300", "TEGO Rad2500", "TEGO Rad2600", "TEGO Rad2650", "TEGO Rad2700", "TEGO Flow300", "TEGO Flow370", "TEGO Flow425", "TEGO Flow ATF2", "TEGO Flow ZFS460", "TEGO Glide100", "TEGO Glide110", "TEGO Glide130", "TEGO Glide410", "TEGO Glide411", "TEGO Glide415", "TEGO Glide432", "TEGO Glide440", "TEGO Glide450", "TEGO Glide482", "TEGO Glide A115", "TEGO Glide B1484", "TEGO Glide ZG400", "TEGO Twin4000", "TEGO Twin4100", "TEGO Twin4200", "TEGO Wet240", "TEGO Wet250", "TEGO Wet260", "TEGO Wet265", "TEGO Wet270", "TEGO Wet280", "TEGO Wet500", "TEGO Wet505", "TEGO Wet510", "TEGO Wet520", and "TEGO Wet KL245" (all above available from Evonik Industries AG).

Other specific examples of the leveling agent include "FC-4430" and "FC-4432" (available from 3M Japan Limited), "UNIDYNE NS" (available from DAIKIN INDUSTRIES, LTD, "UNIDYNE" is a registered trademark), and "SURFLON S-241", "SURFLON S-242", "SURFLON S-243", "SURFLON S-420", "SURFLON S-611", "SURFLON S-651", and "SURFLON S-386" (all above available from AGC Seimi Chemical Co., Ltd., SURFRON is a registered trademark).

Other specific examples of the leveling agent include "DISPARLON OX-880EF", "DISPARLON OX-881", "DISPARLON OX-883", "DISPARLON OX-77EF", "DISPARLON OX-710", "DISPARLON 1922", "DISPARLON 1927", "DISPARLON 1958", "DISPARLON P-410EF", "DISPARLON P-420", "DISPARLON P-425", "DISPARLON PD-7", "DISPARLON 1970", "DISPARLON 230", "DISPARLON LF-1980", "DISPARLON LF-1982", "DISPARLON LF-1983", "DISPARLON LF-1084", "DISPARLON LF-1985", "DISPARLON LHP-90", "DISPARLON LHP-91", "DISPARLON LHP-95", "DISPARLON LHP-96", "DISPARLON OX-715", "DISPARLON 1930N", "DISPARLON 1931", "DISPARLON 1933", "DISPARLON 1934", "DISPARLON 1711EF", "DISPARLON 1751N", "DISPARLON 1761", "DISPARLON LS-009", "DISPARLON LS-001", and "DISPARLON LS-050" (all above available from Kusumoto Chemicals, Ltd.).

Other examples of the leveling agent include "PF-151N", "PF-636", "PF-6320", "PF-656", "PF-6520", "PF-652-NF", and "PF-3320" (all above available from OMNOVA SOLUTIONS Inc.); "POLYFLOW No.7", "POLYFLOW No.50E", "POLYFLOW No.50EHF", "POLYFLOW No.54N", "POLYFLOW No.75", "POLYFLOW No.77", "POLYFLOW No.85", "POLYFLOW No.85HF", "POLYFLOW No.90", "POLYFLOW No.90D-50", "POLYFLOW No.95", "POLYFLOW No.99C", "POLYFLOW KL-400K", "POLYFLOW KL-400HF", "POLYFLOW KL-401", "POLYFLOW KL-402", "POLYFLOW KL-403", "POLYFLOW KL-404", "POLYFLOW KL-100", "POLYFLOW LE-604", "POLYFLOW KL-700", "FLOWLEN AC-300", "FLOWLEN AC-303", "FLOWLEN AC-324", "FLOWLEN AC-326F", "FLOWLEN AC-530", "FLOWLEN AC-903", "FLOWLEN AC-903HF", "FLOWLEN AC-1160", "FLOWLEN AC-1190", "FLOWLEN AC-2000", "FLOWLEN AC-2300C", "FLOWLEN AO-82", "FLOWLEN AO-98", and "FLOWLEN AO-108" (all above available from Kyoeisha Chemical Co., Ltd.).

Other specific examples of the leveling agent include "L-7001", "L-7002", "8032ADDITIVE", "57ADDTIVE", "L-7064", "FZ-2110", "FZ-2105", "67ADDTIVE", and "8616ADDTIVE" (all above available from Toray Dow Silicone Co., Ltd.).

The amount of the leveling agent added is preferably 0.005 to 2% by mass and more preferably 0.01 to 0.5% by mass with respect to the total amount of the photopolymerizable compound contained in the ink composition.

<<Chain Transfer Agent>>

The chain transfer agent is a component used, for example, to improve the adhesion of the ink composition to

the base.

Examples of the chain transfer agent include aromatic hydrocarbons; halogenated hydrocarbons such as chloroform, carbon tetrachloride, carbon tetrabromide, and bromotrichloromethane; mercaptan compounds such as octyl mercaptan, n-butyl mercaptan, n-pentyl mercaptan, n-hexadecyl mercaptan, n-tetradecyl mer, n-dodecyl mercaptan, t-tetradecyl mercaptan, and t-dodecyl mercaptan; thiol compounds such as hexanedithiol, decandithiol, 1,4-butanediol bisthiopropionate, 1,4-butanediol bisthioglycolate, ethylene glycol bisthioglycolate, ethylene glycol bisthiopropionate, trimethylolpropane tristhioglycolate, trimethylolpropane tristhiopropionate, trimethylolpropane tris(3-mercaptobutyrate), pentaerythritol tetrakisthioglycolate, pentaerythritol tetrakisthiopropionate, tris(2-hydroxyethyl) trimercaptopropionate isocyanurate, 1,4-dimethylmercaptobenzene, 2,4,6-trimercapto-s-triazine, and 2-(N,N-dibutylamino)-4,6-dimercapto-s-triazine; sulfide compounds such as dimethylxanthogen disulfide, diethylxantogen disulfide, diisopropylxantogen disulfide, tetramethylthiuram disulfide, tetraethylthiuram disulfide, and tetrabutylthiuram disulfide; N,N-dimethylaniline, N,N-divinylaniline, pentaphenylethane, α-methylstyrene dimer, acrolein, allyl alcohol, terpinolene, α-terpinene, γ-terpinene, and dipentene, and 2,4-diphenyl-4-methyl-1-pentene and thiol compounds are preferred.

As specific examples of the chain transfer agent, compounds represented by the following general formulas (9-1) to (9-12) are preferred.

[chem. 16]

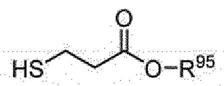

(9-1)

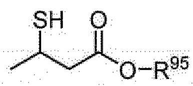

(9-2)

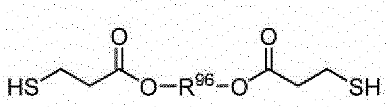

(9-3)

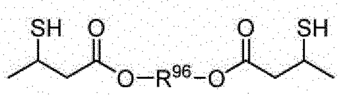

(9-4)

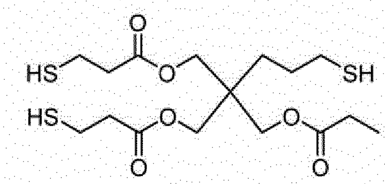

(9-5)

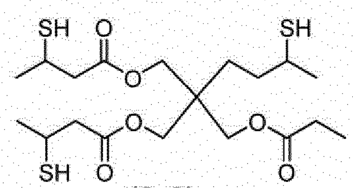

(9-6)

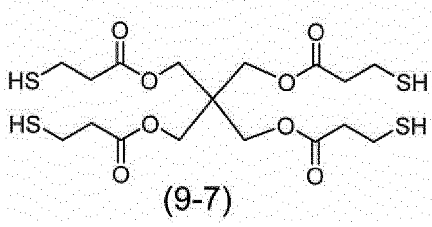

(9-7)

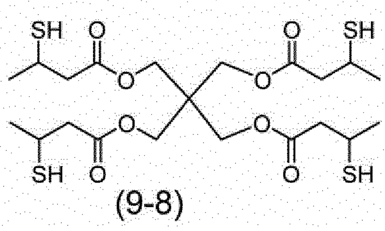

(9-8)

[chem. 17]

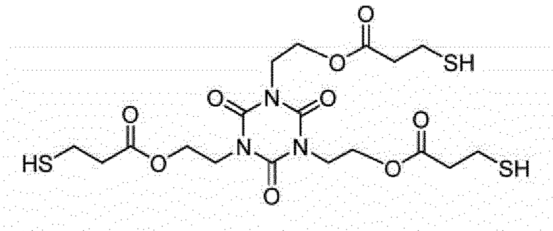

(9-9)

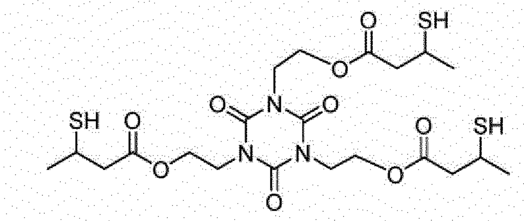

(9-10)

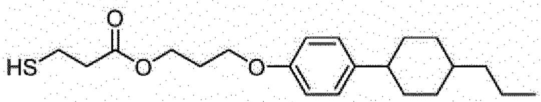

(9-11)

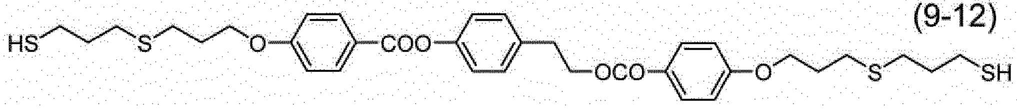

(9-12)

In the formula, $R^{95}$ represents an alkyl group having 2 to 18 carbon atoms, where the alkyl group may be linear or branched, and one or more methylene groups in the alkyl group may be substituted with an oxygen atom, a sulfur atom, -CO-, -OCO-, -COO-, or -CH= CH- without an oxygen atom and a sulfur atom being directly bonded to each other.

$R^{96}$ represents an alkylene group having 2 to 18 carbon atoms, where one or more methylene groups in the alkylene group may be substituted with an oxygen atom, a sulfur atom, -CO-, -OCO-, -COO-, or -CH=CH- without an oxygen atom and a sulfur atom being directly bonded to each other.

The amount of the chain transfer agent added is preferably 0.1 to 10% by mass and more preferably 1.0 to 5% by mass with respect to the total amount of the photopolymerizable compound contained in the ink composition.

<<Dispersion Aid>>

Examples of the dispersion aid include organic pigment derivatives such as phthalimide methyl derivatives, phthalimide sulfonic acid derivatives, phthalimide N-(dialkylamino)methyl derivatives, and phthalimide N-(dialkylaminoalkyl) sulfonic acid amide derivatives. These dispersion aids may be used singly or may be used in combination of two or more.

<<Thermoplastic Resin>>

Examples of the thermoplastic resin include urethane resins, acrylic resins, polyamide resins, polyimide resins, styrene maleic acid resins, styrene maleic anhydride resins, and polyester acrylate resins.

<<Sensitizer>>

As the sensitizer, amines that do not cause an addition reaction with the photopolymerizable compound can be used. Examples of such sensitizers include trimethylamine, methyl dimethanolamine, triethanolamine, p-diethylaminoacetophenone, ethyl p-dimethylaminobenzoate, isoamyl p-dimethylaminobenzoate, N,N-dimethyl benzylamine, and 4,4'-bis(diethylamino)benzophenone.

<<Light-Scattering Particles>>

The light-scattering particles are preferably, for example, optically inactive inorganic particles. The light-scattering particles can scatter light from a light source that irradiates the light-emitting layer (light conversion layer).

Examples of materials that constitute the light-scattering particles include single metals such as tungsten,

zirconium, titanium, platinum, bismuth, rhodium, palladium, silver, tin, platinum, and gold; metal oxides such as silica, barium sulfate, barium carbonate, calcium carbonate, talc, titanium oxide, clay, kaolin, barium sulfate, barium carbonate, calcium carbonate, alumina white, titanium oxide, magnesium oxide, barium oxide, aluminum oxide, bismuth oxide, zirconium oxide, and zinc oxide; metal carbonates such as magnesium carbonate, barium carbonate, bismuth subcarbonate, and calcium carbonate; metal hydroxides such as aluminum hydroxide; composite oxides such as barium zirconate, calcium zirconate, calcium titanate, barium titanate, and strontium titanate, and metal salts such as bismuth subnitrate.

Among them, as the materials that constitute the light-scattering particles, it is preferable to include at least one selected from the group consisting of titanium oxide, alumina, zirconium oxide, zinc oxide, calcium carbonate, barium sulfate, and silica, in terms of excellent light leakage reduction effects, and it is more preferable to include at least one selected from the group consisting of titanium oxide, barium sulfate, and calcium carbonate.

In terms of ejection stability in inkjet printing, the viscosity of the ink composition is preferably in the range of 2 to 20 mPa·s, more preferably in the range of 5 to 15 mPa·s, and even more preferably in the range of 7 to 12 mPa·s. In this case, since the meniscus shape of the ink composition in the ink ejection hole of the ejection head is stabilized, the ejection control of the ink composition (e.g., control of ejection amount and ejection timing) is easy. In addition, the ink composition can be ejected smoothly from the ink ejection hole. The viscosity of the ink composition can be measured, for example, by an E-type viscometer.

It is preferable that the surface tension of the ink composition is a surface tension suitable for an inkjet printing method. Specific values of the surface tension are preferably in the range of 20 to 40 mN/m and more preferably in the range of 25 to 35 mN/m. With the surface tension set in the above range, misdirection of droplets of the ink composition can be suppressed. As used herein misdirection means that when the ink composition is ejected from the ink ejection hole, the landing position of the ink composition deviates from the target position by 30 um or more.

The ink composition described above can be prepared by dispersing the light-emitting particles in a solution in which the photopolymerizable compound, the photopolymerization initiator, and the like are mixed. The light-emitting particles can be dispersed, for example, using a disperser such as a ball mill, a sand mill, a bead mill, a three-roll mill, a paint conditioner, an attritor, a dispersion stirrer, or an ultrasonic disperser.

<Ink Composition Set>

Another embodiment of the present invention is an ink composition set. The ink composition set of an embodiment includes the ink composition of the foregoing embodiment. The ink composition set may include an ink composition that does not contain light-emitting particles (non-light-emitting ink composition), in addition to the ink composition of the foregoing embodiment (light-emitting ink composition). The non-light-emitting ink composition is, for example, a curable ink composition. The non-light-emitting ink composition may be a conventionally known ink composition and may be a composition similar to the ink composition (light-emitting ink composition) of the foregoing embodiment, except it does not contain light-emitting particles.

Since the non-light-emitting ink composition does not contain light-emitting particles, light emitted from a pixel unit when light is incident on the pixel unit formed of the non-light-emitting ink composition (the pixel unit containing a cured product of the non-light-emitting ink composition) has substantially the same wavelength as that of the incident light. The non-light-emitting ink composition is therefore suitably used for forming a pixel unit of the same color as light from a light source. For example, when light from a light source is light having a wavelength in the range of 420 to 480 nm (blue light), a pixel unit formed of the non-light-emitting ink composition can be a blue pixel unit.

The non-light-emitting ink composition preferably contains light-scattering particles. When the non-light-emitting ink composition contains light-scattering particles, the pixel unit formed of the non-light-emitting ink composition can scatter light incident on the pixel unit, thereby reducing the light intensity difference of light emitted from the pixel units in the viewing angle.

The light-emitting particle dispersion of the present invention is also suitable for light conversion film applications. Examples of the method for carrying the light-emitting particle dispersion of the present invention on a substrate include spin coating, die coating, extrusion coating, roll coating, wire bar coating, gravure coating, spray coating, dipping, inkjet process, and printing process. In coating, an organic solvent may be added to the light-emitting particle dispersion. Examples of the organic solvent include hydrocarbon solvents, halogenated hydrocarbon solvents, ether solvents, alcohol solvents, ketone solvents, ester solvents, and nonprotonic solvents. In terms of stability of the light-emitting particles, hydrocarbon solvents, halogenated hydrocarbon solvents, and ester solvents are preferred. Specific examples of the organic solvent include toluene, hexane, heptane, cyclohexane, and methylcyclohexane. These may be used singly or in combination and are selected as appropriate in consideration of their vapor pressure and solubility in the composition containing light-emitting particles. As a method for volatilizing the added organic solvent, natural drying, heating drying, decompression drying, and decompression and heating drying can be used. The film thickness of the film may be adjusted as appropriate according to the applications. For example, the film thickness is preferably 0.1 um or more and

10 mm or less and particularly preferably 1 um or more and 1 mm or less.

The shape of the substrate on which the light-emitting particle dispersion of the present invention is carried may be a flat plate or may have a curved surface as a constituent part. The material of the substrate may be either an organic material or an inorganic material. Examples of the organic material as the material of the substrate include polyethylene terephthalate, polycarbonate, polyimide, polyamide, polymethyl methacrylate, polystyrene, polyvinyl chloride, polytetrafluoroethylene, polychlorotrifluoroethylene, polyarylate, polysulfone, triacetylcellulose, cellulose, and polyetheretherketone. Examples of the inorganic material include, for example, silicon, glass, and calcite.

When the light-emitting particle dispersion of the present invention is carried on a substrate and polymerized, it is preferable to polymerize by irradiation with active energy beams such as ultraviolet rays or electron beams, because it is desired that the polymerization proceeds quickly. The temperature in irradiation is preferably within a temperature range in which the particle shape of the light-emitting particles of the present invention is maintained. When the film is to be produced by photopolymerization, it is preferable to polymerize at temperatures as close to room temperature as possible, that is, typically 25°C, in order to avoid unintended induction of thermal polymerization. The intensity of the active energy beams is preferably 0.1 $mW/cm^2$ or more and 2.0 $W/cm^2$ or less. When the intensity is less than 0.1 $mW/cm^2$, a large amount of time is required to complete photopolymerization and the productivity is reduced, and when the intensity is higher than 2.0 $W/cm^2$, the light-emitting particles or the light-emitting particle dispersion may be deteriorated.

The light conversion film made of the light-emitting particle dispersion obtained by polymerization as the forming material can be subjected to heat treatment in order to reduce change of initial properties and stably exhibit the properties. The temperature of the heat treatment is preferably in the range of 50 to 250°C, and the heat treatment time is preferably in the range of 30 seconds to 12 hours.

The light conversion film made of the light-emitting particle dispersion of the present invention produced by such a method as the forming material may be peeled off from the substrate and used alone or may be used without being peeled off. The resulting light conversion film may be laminated or may be bonded to another substrate.

When the light conversion film made of the light-emitting particle dispersion of the present invention as the forming material is used in a laminated structure, the laminated structure may have any layers, such as a substrate, a barrier layer, and a light scattering layer. Examples of the material that constitutes the substrate include those described above. As a configuration example of the laminated structure, for example, the light conversion film made of the light-emitting particle dispersion of the present invention as the forming material may be sandwiched between two substrates. In such a case, the outer periphery between the substrates may be sealed with a sealing material in order to protect the light conversion film made of the light-emitting particle dispersion as the forming material from moisture and oxygen in the air. Examples of the barrier layer include polyethylene terephthalate and glass. The laminated structure may have a light scattering layer in order to scatter light uniformly. Examples of the light scattering layer include a layer containing the above light-scattering particles and a light diffusion film. Fig. 1 is a cross-sectional view schematically illustrating a configuration of the laminated structure of the present embodiment. In Fig. 1, hatching indicating a cross section is omitted in order to avoid complication of the drawing. A laminated structure 50 has a light conversion film 54 of the present embodiment sandwiched between a first substrate 51 and a second substrate 52. The optical film 54 is formed using a light-emitting particle dispersion containing light-scattering particles 541 and light-emitting particles 542 as a forming material. The light-scattering particles 541 and the light-emitting particles 542 are uniformly dispersed in the light conversion film. The light conversion film 54 is sealed by a sealing layer 53 formed of a sealing material.

The laminated structure containing the light-emitting particles of the present invention is suitable for light-emitting device applications. Examples of the configuration of the light-emitting device include a prism sheet, a light guide plate, and a structure having a laminated structure containing the light-emitting particles of the present invention and a light source. Examples of the light source include light-emitting diodes, lasers, and electroluminescence devices.

It is preferable that the laminated structure containing the light-emitting particles of the present invention is used as a wavelength conversion member for displays. As a configuration example for use as a wavelength conversion member, for example, a laminated structure in which a light conversion film made of a composition containing the light-emitting particles of the present invention as a forming material is sealed between two barrier layers is installed on a light guide plate. In this case, blue light from a light-emitting diode installed on a side surface of the light guide plate is passed through the laminated structure and thereby converted into green light or red light, and can be used as backlight for displays.

<Light Conversion Layer, Color Filter, and Light-Emitting Element>

Other embodiments of the present invention are a light conversion layer, a color filter, and a light-emitting element. The details of the light conversion layer and the color filter obtained using the ink composition or the ink composition set of the foregoing embodiments will be described below with reference to the drawings. However, the following embodiments are embodiments in which the ink composition contains light-scattering particles. In the following

description, like or equivalent elements are denoted by like signs, and an overlapping description is omitted.

Fig. 2 is a schematic cross-sectional view of the color filter of an embodiment. As illustrated in Fig. 2, a color filter 100 includes a base 40 and a light conversion layer 30 provided on the base 40. The light conversion layer 30 has a plurality of pixel units 10 and a light-shielding unit 20.

The light conversion layer 30 has a first pixel unit 10a, a second pixel unit 10b, and a third pixel unit 10c as the pixel units 10. The first pixel unit 10a, the second pixel unit 10b, and the third pixel unit 10c are arranged in a grid pattern such that they are repeated in this order. The light-shielding unit 20 is provided between adjacent pixel units, that is, between the first pixel unit 10a and the second pixel unit 10b, between the second pixel unit 10b and the third pixel unit 10c, and between the third pixel unit 10c and the first pixel unit 10a. In other words, these adjacent pixel units are spaced apart from each other by the light-shielding unit 20.

The first pixel unit 10a and the second pixel unit 10b are pixel units emitting light (light-emitting pixel units), each containing a cured product of the ink composition of the foregoing embodiment. The cured product illustrated in Fig. 1 contains light-emitting particles, a cured component, and light-scattering particles. The first pixel unit 10a contains a first cured component 13a, and first light-emitting particles 11a and first light-scattering particles 12a dispersed in the first cured component 13a. Similarly, the second pixel unit 10b contains a second cured component 13b, and second light-emitting particles 11b and second light-scattering particles 12b dispersed in the second cured component 13b. The cured component is a component obtained by polymerization of the photopolymerizable compound and contains a polymer of the photopolymerizable compound. In addition to the above polymer, the cured component may contain components other than the organic solvent contained in the ink composition. In the first pixel unit 10a and the second pixel unit 10b, the first cured component 13a and the second cured component 13b may be the same or different, and the first light-scattering particle 12a and the second light-scattering particle 12b may be the same or different.

The first light-emitting particle 11a is a red light-emitting nanocrystal particle that absorbs light with a wavelength in the range of 420 to 480 nm and emits light with an emission peak wavelength in the range of 605 to 665 nm. In other words, the first pixel unit 10a can be said as a red pixel unit for converting blue light into red light. The second light-emitting particle 11b is a green light-emitting nanocrystal particle that absorbs light with a wavelength in the range of 420 to 480 nm and emits light with an emission peak wavelength in the range of 500 to 560 nm. In other words, the second pixel unit 10b can be said as a green pixel unit for converting blue light into green light.

The amount of the light-emitting particles contained in the light-emitting pixel unit is preferably 1% by mass or more, 2% by mass or more, or 3% by mass or more, with respect to the total mass of the cured product of the light-emitting ink composition, in terms of more excellent external quantum efficiency-improving effect and achieving excellent emission intensity. The amount of the light-emitting particles contained is preferably 15% by mass or less, 10% by mass or less, or 7% by mass or less, with respect to the total mass of the cured product of the light-emitting ink composition, in terms of excellent reliability of the pixel units and achieving excellent emission intensity.

The amount of the light-scattering particles contained in the light-emitting pixel unit may be 0.1% by mass or more, 1% by mass or more, or 3% by mass or more, with respect to the total mass of the cured product of the light-emitting ink composition, in terms of more excellent external quantum efficiency-improving effect. The amount of the light-scattering particles contained may be 30% by mass or less, 25% by mass or less, 20% by mass or less, 15% by mass or less, or 10% or less, with respect to the total mass of the cured product of the light-emitting ink composition, in terms of more excellent effect of improving external quantum efficiency and excellent reliability of the pixel units.

The third pixel unit 10c is a pixel unit not emitting light (non-light-emitting pixel unit) that contains the cured product of the above non-light-emitting ink composition. The cured product does not contain light-emitting particles and contains light-scattering particles and a cured component. In other words, the third pixel unit 10c contains a third cured component 13c and third light-scattering particles 12c dispersed in the third cured component 13c. The third cured component 13c is, for example, a component obtained by polymerization of a polymerizable compound and contains a polymer of the polymerizable compound. The third light-scattering particle 12c may be the same as or different from the first light-scattering particle 12a and the second light-scattering particle 12b.

The third pixel unit 10c has, for example, a transmittance of 30% or more for light with a wavelength in the range of 420 to 480 nm. Thus, the third pixel unit 10c functions as a blue pixel unit when a light source emitting light with a wavelength in the range of 420 to 480 nm is used. The transmittance of the third pixel unit 10c can be measured by a microscope spectrometer.

The amount of the light-scattering particles contained in the non-light-emitting pixel unit may be 1% by mass or more, 5% by mass or more, or 10% by mass or more, with respect to the total mass of the cured product of the non-light-emitting ink composition, in terms of further reducing light intensity differences in the viewing angle. The amount of the light-scattering particles contained may be 80% by mass or less, 75% by mass or less, or 70% by mass or less, with respect to the total mass of the cured product of the non-light-emitting ink composition, in terms of further reducing light reflection.

The thickness of the pixel unit (first pixel unit 10a, second pixel unit 10b, and third pixel unit 10c) may be, for example, 1 um or more, 2 um or more, or 3 um or more. The thickness of the pixel unit (first pixel unit 10a, second pixel

unit 10b, and third pixel unit 10c) may be, for example, 30 um or less, 20 um or less, or 15 um or less.

The light-shielding unit 20 is a so-called black matrix, which is provided to separate adjacent pixel units to prevent color mixing and to prevent light leakage from the light source. The material that constitutes the light-shielding unit 20 is not limited, and metal such as chromium, a cured product of a resin composition containing light-shielding particles such as carbon nanoparticles, metal oxide, inorganic pigment, and organic pigment in a binder polymer, or the like can be used. As the binder polymer used here, a mixture of one or more resins such as polyimide resin, acrylic resin, epoxy resin, polyacrylamide, polyvinyl alcohol, gelatin, casein, and cellulose, a photosensitive resin, an O/W emulsion-type resin composition (e.g., an emulsion of reactive silicone), and the like can be used. The thickness of the light-shielding unit 20 may be, for example, 0.5 um or more and may be 10 um or less.

The base 40 is a transparent base material having light transmittance. For example, a transparent glass substrate such as quartz glass, Pyrex (registered trademark) glass, or synthetic quartz plate, or a transparent flexible base material such as a transparent resin film or an optical resin film can be used. Among them, it is preferable to use a glass substrate made of alkali-free glass that does not contain alkali components in glass. Specifically, "7059 Glass", "1737 Glass", "Eagle 200", and "Eagle XG" from Corning Incorporated, and "AN100" from Asahi Glass Co., Ltd., and "OA-10G" and "OA-11" from Nippon Electric Glass Co., Ltd. are suitable. These are materials with a low thermal expansion coefficient and are excellent in dimensional stability and workability in high temperature heat treatment.

The color filter 100 having the above light conversion layer 30 is suitably used when a light source emitting light with a wavelength in the range of 420 to 480 nm is used.

The color filter 100 can be produced, for example, by forming the light-shielding unit 20 in a pattern on the base 40 and then forming the pixel units 10 in a pixel unit-forming region defined by the light-shielding unit 20 on the base 40. The pixel units 10 can be formed by a method including the steps of: selectively depositing an ink composition (inkjet ink) in the pixel unit-forming region on the base 40 by an inkjet method; and irradiating the ink composition with active energy beams (e.g., UV rays) to cure the ink composition to obtain light-emitting pixel units. The above light-emitting ink composition can be used as the ink composition to obtain a light-emitting pixel unit, and the non-light-emitting ink composition can be used to obtain a non-light-emitting pixel unit.

An example of the method of forming the light-shielding unit 20 includes forming a thin film of metal such as chromium or a thin film of a resin composition containing light-shielding particles in a region serving as a boundary between a plurality of pixel units on one side of the base 40, and patterning this thin film. The thin film of metal can be formed, for example, by sputtering or vacuum evaporation, and the thin film of a resin composition containing light-shielding particles can be formed, for example, by a method such as coating or printing. Examples of the method of patterning include photolithography.

Examples of the inkjet method include a bubble jet (registered trademark) method using an electro-thermal converter as an energy generating element, and a piezo-jet method using a piezoelectric element.

The ink composition can be cured using, for example, a mercury lamp, a metal halide lamp, a xenon lamp, or an LED. The wavelength of the irradiating light may be, for example, 200 nm or more and may be 440 nm or less. The exposure dose may be, for example, 10 $mJ/cm^2$ or more and may be 4000 $mJ/cm^2$ or less.

For example, the light conversion layer may include a pixel unit (blue pixel unit) containing a cured product of a light-emitting ink composition containing blue light-emitting nanocrystal particles, instead of the third pixel unit 10c or in addition to the third pixel unit 10c. The light conversion layer may include a pixel unit (e.g., yellow pixel unit) containing a cured product of a light-emitting ink composition containing nanocrystal particles that emit light in a color other than red, green, and blue. In these cases, each of the light-emitting particles contained in each pixel unit of the light conversion layer preferably has an absorption maximum wavelength in the same wavelength range.

At least some of the pixel units of the light conversion layer may contain a cured product of a composition containing a pigment other than light-emitting particles.

The color filter may include an ink-repellent layer composed of an ink-repellent material in a width narrower than the light-shielding unit, on the pattern of the light-shielding unit. Instead of providing an ink-repellent layer, a photocatalyst-containing layer as a wettability-variable layer may be formed in a solid manner in a region including the pixel unit-forming region, and then the photocatalyst-containing layer may be exposed to light with a photomask interposed to selectively increase the ink affinity in the pixel unit-forming region. Examples of the photocatalyst include titanium oxide and zinc oxide.

The color filter may include an ink-receiving layer containing hydroxypropyl cellulose, polyvinyl alcohol, gelatin, or the like between the base and the pixel unit.

The color filter may include a protective layer on the pixel unit. This protective layer is provided to planarize the color filter and to prevent elution of a component contained in the pixel unit, or a component contained in the pixel unit and a component contained in the photocatalyst-containing layer into the liquid crystal layer. As a material that constitutes the protective layer, those used as known protective layers for color filters can be used.

In production of the color filter and the light conversion layer, the pixel units may be formed by photolithography instead of an inkjet method. In this case, the ink composition is first applied in the form of a layer on the base to form

an ink composition layer. The ink composition layer is then exposed in a pattern and developed using a developer. In this way, the pixel units composed of a cured product of the ink composition are formed. Since the developer is usually alkaline, an alkaline soluble material is used as a material of the ink composition. However, the inkjet method is superior to photolithography in terms of the efficiency of material use. This is because in photolithography, in principle, almost 2/3 or more of the material is removed and the material is wasted. For this reason, in the present embodiment, it is preferable to use an inkjet ink and form pixel units by the inkjet method.

In addition to the above light-emitting particles, the pixel units of the light conversion layer of the present embodiment may further contain a pigment of a color substantially the same as the emission color of the light-emitting particles. A pigment may be contained in the ink composition in order to include a pigment in the pixel units.

One or two kinds of light-emitting pixel units among the red pixel unit (R), the green pixel unit (G), and the blue pixel unit (B) in the light conversion layer of the present embodiment may be a pixel unit that does not contain light-emitting particles but contains a colorant. As the colorant that can be used herein, known colorants can be used. Examples of the colorant used for the red pixel unit (R) include diketopyrrolopyrrole pigments and/or anionic red organic dyes. An example of the colorant used for the green pixel unit (G) is at least one selected from the group consisting of copper phthalocyanine halide pigments, phthalocyanine green dyes, and mixtures of phthalocyanine blue dyes and azo yellow organic dyes. An example of the colorant used for the blue pixel unit (B) is ε-type copper phthalocyanine pigment and/or cationic blue organic dye. When these colorants are contained in the light conversion layer, it is preferable that the amount of these colorants used is 1 to 5% by mass with respect to the total mass of the pixel unit (cured product of the ink composition) in terms of preventing decrease in transmittance.

The above color filter can be used as a color filter for organic electroluminescent elements (OLEDs) and liquid crystal displays, which are light-emitting elements. The present invention is particularly useful for an organic electroluminescent element (OLED). The configuration of the organic electroluminescent element will be briefly described below.

The light-emitting element, which is an organic electroluminescent element, is a light-emitting element that has an organic EL light source defined for each pixel on a substrate, and a color filter disposed above the organic EL light source to convert blue light emitted from the organic EL light source into read (R) or green (G). The organic EL light source defined for each pixel may include a filling layer and a protective layer together with an organic EL light-emitting member.

Such a light-emitting element can absorb and re-emit or transmit light emitted from the organic EL light source (EL layer) through the color filter, so that red, green, or blue light can be extracted from the upper substrate side to the outside.

[Examples]

The present invention will be described in detail below with examples, but the present invention is not limited to these examples. Unless otherwise specified, "part" and "%" are on a mass basis.

[Synthesis of Polymer B]

<Synthesis Example 1>

In a reaction vessel, 15 parts of 12-hydroxystearic acid, 285 parts of ε-caprolactone, and 0.05 parts of monobutyltin oxide as a catalyst were charged with nitrogen purging, and then heated and stirred at 120°C for four hours to obtain a polyester intermediate. Then, 100 parts of a 10% aqueous solution of polyarylamine ("PAA-1LV" from NITTO BOSEKI CO., LTD., number average molecular weight of approximately 3,000) was stirred at 160°C in a reaction vessel, and water was removed using a separator. To this, 200 parts of the polyester intermediate heated to 160°C was added and allowed to react at 160°C for two hours, resulting in a graft copolymer B4. The weight average molecular weight (Mw) of the resulting polymer, determined by gel permeation chromatography (GPC) under the conditions described below, was 44,000 in terms of polystyrene, and the polymer was a pale yellow solid at room temperature.

<Synthesis Example 2>

In a reaction vessel, 6 parts of polyethyleneimine ("Epomin SP-018" from NIPPON SHOKUBAI CO., LTD.), 60 parts of ε-caprolactone, 40 parts of δ-valerolactone, 15 parts of 12-hydroxystearic acid, and 0.05 parts of dibutyltin dilaurate were mixed and allowed to react at 170°C for five hours, resulting in a graft copolymer B5. The weight average molecular weight (Mw) of the resulting polymer, determined by gel permeation chromatography (GPC) under the conditions described below, was 25,000 in terms of polystyrene, and the polymer was a brown liquid at room temperature.

[Measurement Conditions of Weight Average Molecular Weight (Mw) Using GPC]

Gel permeation chromatography (GPC) was performed using lithium bromide dissolved at a concentration of 10 mmol/L in N,N-dimethylformamide as the eluent [Tosoh Corporation, GPC system (HLC-8220GPC), columns from Tosoh Corporation (TSK-GEL super AWM-H, 2 columns), flow rate: 0.6 mL/min], using polystyrene as the standard material.

<Example 1>

[Preparation of Light-Emitting Particle Dispersion]

(Step S1)

First, 0.12 g of cesium carbonate, 5 mL of 1-octadecene, and 0.5 mL of oleic acid were mixed to obtain a mixture. The mixture was then dried under reduced pressure at 120°C for 30 minutes and then heated at 150°C under an argon atmosphere. A cesium-oleic acid solution was thus obtained.

Meanwhile, 0.1 g of lead(II) bromide, 7.5 mL of 1-octadecene, and 0.75 mL of oleic acid were mixed to obtain a mixture. The mixture was then dried under reduced pressure at 90°C for 10 minutes, and thereafter 0.75 mL of 3-aminopropyltriethoxysilane (APTES) was added to the mixture under an argon atmosphere. Subsequently, the mixture was further dried under reduced pressure for 20 minutes and then heated at 140°C under an argon atmosphere.

Subsequently, 0.75 mL of the cesium-oleic acid solution was added to the mixture containing lead(II) bromide at 150°C, and the mixture was heated and stirred for five seconds and then cooled in an ice bath. Then, 60 mL of methyl acetate was added. The resulting suspension was centrifuged (10,000 rpm for one minute) and the supernatant was removed, resulting in a solid matter containing precursor particles P1. The nanocrystal constituting the precursor particle P1 was a perovskite-type lead cesium tribromide crystal, and its average particle size was 10 nm as analyzed by scanning transmission electron microscopy.

(Step S2)

As the polymer B, 800 mg of block copolymer (S2VP from Polymer Source., Inc.) having the structure represented by the following formula (B6) was added to 80 mL of toluene and dissolved by heating at 60°C. To the solid matter containing the precursor particles P1, 80 mL of the toluene in which the block copolymer was dissolved was added, stirred for 15 minutes, and then centrifuged, and the supernatant was collected, resulting in a toluene dispersion liquid containing the precursor particles and the block copolymer.

[chem. 18]

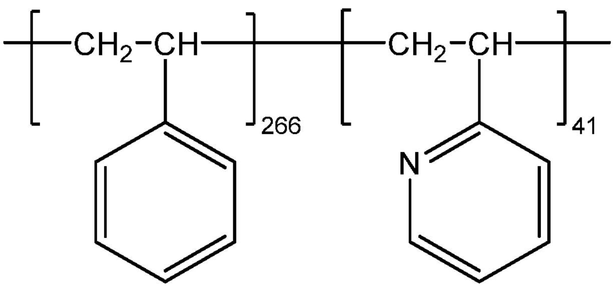

(B6)

(Step S3)

To 2 mL of the toluene dispersion liquid, 10 μL of the compound represented by the following formula (C4) (MS-51 from COLCOAT CO., LTD., the average value of m in the formula (C4) is 4) was added and stirred for five minutes, and then 5 μL of ion-exchanged water was further added and stirred for two hours.

[chem. 19]

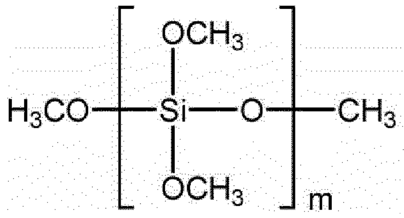

(C4)

The resulting solution was centrifuged at 9,000 rpm for five minutes, and 2 mL of the supernatant was collected to obtain a light-emitting particle dispersion 1 in which light-emitting particles were dispersed in toluene. The average particle size of the light-emitting particles dispersed in the light-emitting particle dispersion as measured using a dynamic light scattering Nanotrac particle size distribution analyzer was 109 nm. The element distribution of the light-emitting particles was evaluated by energy dispersive X-ray analysis (STEM-EDS) using a scanning transmission electron microscope (SEM), and the result is indicated in Fig. 3. Fig. 3 indicates that the surface layer of the light-emitting particle contained Si. The thickness of the surface layer was measured and was approximately 4 nm.

<Example 2>

A light-emitting particle dispersion 2 was prepared in the same manner as in Example 1, except that 0.15 mL of 3-mercaptopropyltriethoxysilane (MPTES) was further added in step S1.

<Example 3>

A light-emitting particle dispersion 3 was prepared in the same manner as in Example 1, except that 0.15 mL of 3-triethoxysilylpropyl succinic anhydride (SAPTES) was further added in step S1.

<Example 4>

A light-emitting particle dispersion 4 was prepared in the same manner as in Example 1, except that "EFKA (registered trademark) PX4701" (from BASF Japan Ltd.) was added as the polymer B instead of S2VP in step S2. EFKA PX4701 is a block copolymer that contains vinylpyridine as the basic first structural unit and a polyethylene glycol structure as the solvophilic second structural unit.

<Example 5>

A light-emitting particle dispersion 5 was prepared in the same manner as in Example 1, except that the polymer B4 synthesized in Synthesis Example 1 was added as the polymer B instead of S2VP, in step S2.

<Example 6>

A light-emitting particle dispersion 6 was prepared in the same manner as in Example 1, except that the polymer B5 synthesized in Synthesis Example 1 was added as the polymer B instead of S2VP, in step S2.

<Comparative Example 1>

A light-emitting particle dispersion 7 was prepared in the same manner as in Example 1, except that no polymer B was added in step S2.

<Comparative Example 2>

A light-emitting particle dispersion 8 was prepared in the same manner as in Example 1, except that the compound represented by the formula (C4) and ion-exchanged water were not added in step S3.

<Comparative Example 3>

A light-emitting particle dispersion 9 was prepared in the same manner as in Example 1, except that no polymer B was added in step S2, and the compound represented by the formula (C4) and ion-exchanged water were not added in step S3.

<Comparative Example 4>

A light-emitting particle dispersion 10 was prepared in the same manner as in Example 1, except that oleylamine was added instead of 3-aminopropyltriethoxysilane in step S1.

<Comparative Example 5>

A light-emitting particle dispersion 11 was prepared in the same manner as in Example 1, except that oleylamine was added instead of 3-aminopropyltriethoxysilane in step S1, no polymer B was added in step S2, and the compound represented by the formula (C4) and ion-exchange water were not added in step S3.

In Table 1, the semiconductor nanocrystal composition, and the silane compound A, the polymer B, and the silane compound C used for the resulting light-emitting particle dispersions 1 to 11 were listed.

[Table 1]

| | Lightemitti ng partic le disper sion | Light-emitting particle | Semicondu ctor nanocryst al compositi on | Silane compound A | Polymer B | Silane compound C |
|---|---|---|---|---|---|---|
| Example 1 | 1 | X-1 | $CsPbBr_3$ | APTES | S2VP | MS-51 |
| Example 2 | 2 | X-2 | $CsPbBr_3$ | APTES MPTES | S2VP | MS-51 |
| Example 3 | 3 | X-3 | $CsPbBr_3$ | APTES SAPTES | S2VP | MS-51 |
| Example 4 | 4 | X-4 | $CsPbBr_3$ | APTES | PX4701 | MS-51 |
| Example 5 | 5 | X-5 | $CsPbBr_3$ | APTES | Polymer B4 | MS-51 |
| Example 6 | 6 | X-6 | $CsPbBr_3$ | APTES | Polymer B5 | MS-51 |
| Comparat ive Example 1 | 7 | X-7 | $CsPbBr_3$ | APTES | None | MS-51 |
| Comparat ive Example 2 | 8 | X-8 | $CsPbBr_3$ | APTES | S2VP | None |
| Comparat ive Example 3 | 9 | X-9 | $CsPbBr_3$ | APTES | None | MS-51 |
| Comparat ive Example 4 | 10 | X-10 | $CsPbBr_3$ | None | S2VP | MS-51 |
| Comparat ive Example 5 | 11 | X-11 | $CsPbBr_3$ | None | None | None |

[Evaluation of Dispersibility]

For each of the light-emitting particle dispersions in Examples and Comparative Examples, the color and state of the dispersion were visually checked immediately after centrifugation in step S3 and after storage for one week. The results are listed in Table 1. The evaluation criteria are as follows. The evaluation for Comparative Example 1 was C, and no further evaluation was conducted, because the light-emitting particles were precipitated by centrifugation and the supernatant after centrifugation was considered to contain virtually no light-emitting particles.

A: Colored in greenish yellow immediately after centrifugation in step S3 and after storage for one week, and no

precipitation was observed even after storage for one week.
B: Colored in greenish yellow immediately after centrifugation in step S3 but changed to colorless after storage for one week, and precipitation occurred.
C: Colorless immediately after centrifugation in step S3.

[Measurement of Initial Quantum Yield]

For each of the light-emitting particle dispersions in Examples and Comparative Examples, the initial quantum yield $QY_0$ was measured using an absolute PL quantum yield spectrometer ("Quantaurus-QY" from Hamamatsu Photonics K.K.). The results are listed in Table 1.

[Evaluation of Stability Against Ethanol]

As mentioned above, perovskite-type semiconductor nanocrystals are easily destabilized for polar solvents such as water, which may lead to decrease in quantum yield. The stability of the light-emitting particles dispersed in the light-emitting particle dispersion against a polar solvent was evaluated using ethanol as a polar solvent. Ethanol was added in 10% by volume to each of the light-emitting particle dispersions in Examples and Comparative Examples and homogenized by stirring, and then the quantum yield $QY_1$ after ethanol addition was measured in the same manner as described above. The quantum yield retention (%) before and after ethanol addition was calculated by the following equation (1). The results are listed in Table 2.

$$\text{Quantum yield retention (\%) before and after ethanol addition} = QY_1/QY_0 \times 100 \quad \ldots (1)$$

[Evaluation of Stability Against Heating]

Light-emitting particles were collected as a solid by volatilizing the toluene in each of the light-emitting particle dispersions in Examples and Comparative Examples using an evaporator, and the initial quantum yield $QY_2$ was measured. The quantum yield $QY_3$ after heating at 100°C for one hour was measured. The quantum yield retention (%) before and after heating was calculated by the following equation (2). The results are listed in Table 2.

$$\text{Quantum yield retention (\%) before and after heating} = QY_3/QY_2 \times 100 \quad \ldots (2)$$

[Table 2]

| | Light-emitting particle dispersion | Dispersibility | Initial quantum yield (%) | Quantum yield retention (%) | |
|---|---|---|---|---|---|
| | | | | Ethanol addition | Heating |
| Example 1 | 1 | A | 81 | 100 | 78 |
| Example 2 | 2 | A | 71 | 100 | 70 |
| Example 3 | 3 | A | 81 | 100 | 78 |
| Example 4 | 4 | A | 72 | 95 | 75 |
| Example 5 | 5 | A | 82 | 100 | 80 |
| Example 6 | 6 | A | 80 | 100 | 73 |
| Comparative Example 1 | 7 | C | - | - | - |

(continued)

| | Light-emitting particle dispersion | Dispersibility | Initial quantum yield (%) | Quantum yield retention (%) | |
|---|---|---|---|---|---|
| | | | | Ethanol addition | Heating |
| Comparative Example 2 | 8 | A | 65 | 82 | 45 |
| Comparative Example 3 | 9 | A | 57 | 81 | 47 |
| Comparative Example 4 | 10 | A | 74 | 38 | 41 |
| Comparative Example 5 | 11 | A | 46 | 13 | 15 |

As listed in Table 2, the light-emitting particle dispersions of Examples 1 to 6 have excellent dispersibility and dispersion stability in the solvent, compared with Comparative Examples 1 to 5. In addition, satisfactory emission intensity can be achieved since the initial quantum yield is high. Furthermore, stability against ethanol as a polar solvent and heat resistance are excellent.

<Example 7>

[Production of Film Containing Light-Emitting Particles]

Two mL of the light-emitting particle dispersion 1 prepared in Example 1 was mixed with 4 mL of hexane, and the resulting suspension was centrifuged at 4,000 rpm for one minute. The supernatant was removed to obtain a solid matter (X-1) containing light-emitting particles.

In a clean room in which light with a wavelength of 500 nm or less was cut off, 26.7 parts by mass of LIGHT ACRYLATE IB-XA (from Kyoeisha Chemical Co., Ltd.), 50 parts by mass of LIGHT ACRYLATE DCP-A (from Kyoeisha Chemical Co., Ltd.), 20 parts by mass of MIRAMER M-3130 (Miwon Specialty Chemical Co., Ltd.), and 3 parts by mass of Omnirad TPO (from IGM Resins) were added in a glass vial with a stirrer, and stirred and dissolved at room temperature. A light-emitting particle dispersion 12 was prepared by adding 0.3 parts by mass of the solid matter (X-1) containing light-emitting particles, stirring and dissolving at room temperature, and filtering the solution through a membrane filter (pore size 0.50 μm). The resulting light-emitting particle dispersion 12 was filtered through a membrane filter (pore size 0.50 um). The resulting light-emitting particle dispersion after filtration was dropped onto a glass substrate EagleXG (from Corning Incorporated) with a 50 μm spacer, another glass substrate EagleXG was placed thereon, and under a nitrogen atmosphere, UV light with a main wavelength of 395 nm was applied with the integral quantity of light of 10 J/cm$^2$ to produce a film with a thickness of 50 um containing light-emitting particles.

[Evaluation of Heat Resistance]

Each of the resulting films containing light-emitting particles was heated for five hours at 80°C and 50% RH in the air under light shielding. The absolute quantum yields (PLQY) of the film before and after heating were measured, and the PLQY retention (%) after heating was determined. The PLQY retention (%) after heating was calculated by the following equation (3).

$$\text{PLQY retention (\%) after heating} = (\text{PLQY of film after heating})/(\text{PLQY of film before heating}) \times 100 \quad \ldots (3)$$

[Evaluation of Light Resistance]

Each of the resulting films containing light-emitting particles was irradiated with blue light with a peak emission wavelength of 450 nm in the air at 60 mW/cm$^2$ at a stage temperature of 30°C for two hours using a light resistance

tester (from CCS Inc.). The absolute quantum yields (PLQY) of the film before and after light radiation were measured, and the PLQY retention (%) after light radiation was determined. The PLQY retention (%) after light radiation was calculated by the following equation (4) .

PLQY retention (%) after light radiation = (PLQY of film after light radiation)/(PLQY of film before light radiation) × 100 … (4)

The PLQY retention (%) after heating and the PLQY retention (%) after light radiation for each of the resulting films containing light-emitting particles are listed in Table 3 below.

<Examples 8 to 12 and Comparative Examples 6 to 9>

Light-emitting particle dispersions 12 to 17 of Examples 8 to 12 and light-emitting particle dispersions 18 to 21 of Comparative Examples 6 to 9 were obtained under the same conditions as in the preparation of the light-emitting particle dispersion 12, except that the light-emitting particle dispersion 1 was changed to the light-emitting particle dispersions listed in Table 2 below.

Films were prepared using the prepared light-emitting particle dispersions, in the same manner as in Example 7, and the absolute quantum yield and the absolute quantum yield retention (%) were evaluated. The results are listed in Table 3.

[Table 3]

| | Light-emitting particle dispersion | Light-emitting particle | PLQY retention after heating | PLQY retention after light radiation |
|---|---|---|---|---|
| Example 7 | 12 | X-1 | 83% | 78% |
| Example 8 | 13 | X-2 | 81% | 75% |
| Example 9 | 14 | X-3 | 85% | 75% |
| Example 10 | 15 | X-4 | 79% | 74% |
| Example 11 | 16 | X-5 | 86% | 82% |
| Example 12 | 17 | X-6 | 80% | 78% |
| Comparative Example 6 | 18 | X-8 | 45% | 37% |
| Comparative Example 7 | 19 | X-9 | 36% | 29% |
| Comparative Example 8 | 20 | X-10 | 30% | 21% |
| Comparative Example 9 | 21 | X-11 | 27% | 12% |

As demonstrated in Examples 7 to 12, the films containing the light-emitting particles of the present invention have a higher PLQY retention (%) after heating and a higher PLQY retention (%) after light radiation than the films containing the light-emitting particles in Comparative Examples 6 to 9, indicating that the stability against moisture, light, and heat is high. This is presumably attributable to that the light-emitting particles of the present invention are less likely to aggregate, so that the resulting film has fewer depressions and protrusions, has a small surface area that may come into contact with water molecules oxygen radicals, and is less likely to be deteriorated.

<Example 13>

[Preparation of Light-Scattering Particle Dispersion Liquid 1]

In a vessel filled with nitrogen gas, 10.0 parts by mass of titanium oxide ("CR60-2" from Ishihara Sangyo Kaisha, Ltd.), 1.0 part by mass of a high-molecular dispersant "Efka PX4701" (amine value: 40.0 mgKOH/g, from BASF Japan Ltd.), and 14.0 parts by mass of phenoxyethyl acrylate (Light Ester PO-A; from Kyoeisha Chemical Co. Ltd.) were mixed. Zirconia beads (diameter: 1.25 mm) were added to the resulting mixture, and the vessel was tightly capped and shaken for two hours using a paint conditioner to disperse the mixture, resulting in a light-diffusing particle dispersion 1. The average particle size of the light-diffusing particles after dispersion was 0.245 um, as measured using NANOTRAC WAVE II.

[Production of Light Conversion Layer Containing Light-Emitting Particles]

In a clean room in which light with a wavelength of 500 nm or less was cut off, 58.5 parts by mass of LIGHT ACRYLATE IB-XA (from Kyoeisha Chemical Co., Ltd.), 29.5 parts by mass of Light Ester 1,6HX (from Kyoeisha Chemical Co., Ltd.), and 3 parts by mass of Omnirad TPO (from IGM Resins) were added in a glass vial with a stirrer, and stirred and dissolved at room temperature. Then, the solid matter (X-1) containing 1.5 parts by mass of light-emitting particles was added and stirred and dissolved at room temperature. A light-emitting particle dispersion 22 was prepared by further adding 8 parts by mass of the light-scattering particle dispersion liquid 1, stirring to make a homogeneous solution, and filtering the solution through a membrane filter (pore size 0.6 μm).

The light-emitting particle dispersion 22 of the present invention was applied on a glass substrate in the air with a spin coater so that the film thickness after drying was 10 um. The coating film was cured by UV irradiation with the integrated quantity of light of 10 J/cm$^2$, using a UV irradiation device with an LED lamp with a main wavelength of 395 nm under a nitrogen atmosphere, and then heated at 180°C for 30 minutes in a glove box with an oxygen concentration of 1% by volume or less to form a light conversion layer composed of a cured product of the dispersion on the glass substrate. The external quantum efficiency retention was evaluated as follows.

[Evaluation of External Quantum Efficiency (EQE)]

An integrating sphere was placed above a blue LED (peak emission wavelength: 450 nm) available from CCS Inc. as a surface emitting light source, and a radiation spectrophotometer from Otsuka Electronics Co., Ltd. (product name "MCPD-9800") was connected to this integrating sphere. Then, the evaluation sample 1 described above was inserted between the blue LED and the integrating sphere, the blue LED was turned on, and the observed spectrum and the illuminance at each wavelength were measured by the radiation spectrophotometer. The external quantum efficiency (EQE) was determined as follows from the determined spectrum and illuminance.

The external quantum efficiency is a value indicating what percentage of light (photons) incident on the light conversion layer is emitted as fluorescence toward the observer. The larger value indicates that the light conversion layer has excellent light-emitting properties, and therefore the external quantum efficiency is an important evaluation index. The external quantum efficiency (EQE) is calculated by the following equation (5).

$$\mathrm{EQE}\ [\%] = \mathrm{P2}/\mathrm{E(Blue)} \times 100 \quad \ldots (5)$$

In the equation, E(Blue) represents the sum of "illuminance × wavelength/hc" in the wavelength range of 380 to 490 nm, and P2 represents the sum of "illuminance × wavelength/hc" in the wavelength range of 500 to 650 nm. These are values corresponding to the observed photon counts. Here, h is Planck’s constant and c is the speed of light.

[Evaluation of Heat Resistance]

The resulting light conversion layer was heated in air at 80°C and 50% RH for 100 hours under light shielding. The external quantum efficiency (EQE) of the light conversion layer before and after heating was measured, and the EQE retention (%) after heating was determined. The EQE retention (%) after heating was calculated by the following equation (6).

EQE retention (%) after heating = (EQE of light conversion layer after heating)/(EQE of light conversion layer before heating) × 100 … (6)

[Evaluation of Light Resistance]

Each of the resulting light conversion layers was irradiated with blue light with a peak emission wavelength of 450 nm in the air at 100 mW/$cm^2$ at a stage temperature of 30°C for 100 hours using a light resistance tester (from CCS Inc.). The external quantum efficiency (EQE) of the light conversion layer before and after light radiation was measured, and the EQE retention (%) after light radiation was calculated by the following equation (7).

EQE retention (%) after light radiation = (EQE of light conversion layer after light radiation)/(EQE of light conversion layer before light radiation) × 100 Eq. (7)

The EQE retention (%) after heating and the EQE retention (%) after light radiation for each of the resulting light conversion layers containing light-emitting particles are listed in Table 4 below.

<Examples 13 to 18 and Comparative Examples 10 to 13>

Light-emitting particle dispersions 23 to 27 of Examples 14 to 18 and light-emitting particle dispersions 28 to 31 of Comparative Examples 10 to 13 were obtained under the same conditions as in the preparation of the light-emitting particle dispersion 22, except that the light-emitting particle dispersion 1 was changed to the light-emitting particle dispersions listed in Table 2 below.

Light conversion layers were prepared using the prepared light-emitting particle dispersions, in the same manner as in Example 13, and the external quantum efficiency and the external quantum efficiency retention (%) were evaluated. The results are listed in Table 4.

[Table 4]

| | Light-emitting particle dispersion | Light-emitting particle | EQE retention after heating | EQE retention after light radiation |
|---|---|---|---|---|
| Example 13 | 22 | X-1 | 91% | 90% |
| Example 14 | 23 | X-2 | 90% | 75% |
| Example 15 | 24 | X-3 | 910 | 75% |
| Example 16 | 25 | X-4 | 85% | 74% |
| Example 17 | 26 | X-5 | 92% | 82% |
| Example 18 | 27 | X-6 | 87% | 78% |
| Comparative Example 10 | 28 | X-8 | 610 | 55% |
| Comparative Example 11 | 29 | X-9 | 50% | 40% |
| Comparative Example 12 | 30 | X-10 | 44% | 32% |
| Comparative Example 13 | 31 | X-11 | 32% | 19% |

As demonstrated in Examples 13 to 18, the light conversion layers containing the light-emitting particles of the present invention have a higher EQE retention (%) after heating and a higher EQE retention (%) after light radiation than the light conversion layers containing the light-emitting particles in Comparative Examples 10 to 13, indicating that the stability against moisture, light, and heat is high.

Based on the above results, it can be expected that excellent light-emitting properties and stability can be achieved when color filter pixel units of a light-emitting element are formed using the light conversion layer containing the light-emitting particles of the present invention.

Reference Signs List

| | |
|---|---|
| 10 | pixel unit |
| 10a | first pixel unit |
| 10b | second pixel unit |
| 10c | third pixel unit |
| 11a | first light-emitting particle |
| 11b | second light-emitting particle |
| 12a | first light-scattering particle |
| 12b | second light-scattering particle |
| 12c | third light-scattering particle |
| 20 | light-shielding unit |
| 30 | light conversion layer |
| 40 | base |
| 50 | laminated structure |
| 51 | first substrate |
| 52 | second substrate |
| 53 | sealing layer |
| 54 | light conversion film |
| 541 | light-scattering particle |
| 542 | light-emitting particle |
| 100 | color filter |

## Claims

1. A method for producing light-emitting particles each having a surface layer containing Si on a surface of a semiconductor nanocrystal particle composed of a metal halide, the method comprising the steps of:

    forming the semiconductor nanocrystal particle and a polysiloxane bond on a surface of the semiconductor nanocrystal particle, from a solution containing a raw material compound for the semiconductor nanocrystal particle, a silane compound A having a binding group capable of binding to the surface of the semiconductor nanocrystal particle and a hydrolyzable silyl group, and a solvent, to obtain a precursor particle having a layer containing a polymer of the silane compound A on the surface of the semiconductor nanocrystal particle;
    mixing the precursor particle, a polymer B containing a first structural unit having a basic group and a second structural unit having no basic group and being solvophilic, and a solvent to obtain a mixture; and
    adding a silane compound C having a hydrolyzable silyl group to the mixture and forming a polysiloxane bond to obtain a light-emitting particle having a layer containing the polymer B and a polymer of the silane compound C on a surface of the precursor particle.

2. The method for producing light-emitting particles according to claim 1, wherein the silane compound A is a compound represented by the following formula (A1):

[chem. 1]

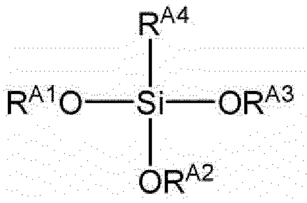

(A1)

where $R^{A1}$, $R^{A2}$, and $R^{A3}$ each independently represent a hydrogen atom or an alkyl group having 1 to 6 carbon atoms, and $R^{A4}$ represents a monovalent group having the binding group.

3. The method for producing light-emitting particles according to claim 1 or 2, wherein the binding group is at least one selected from the group consisting of a carboxyl group, a mercapto group, and an amino group.

4. The method for producing light-emitting particles according to any one of claims 1 to 3, wherein the silane compound C is a compound represented by the following formula (C1):

[chem. 2]

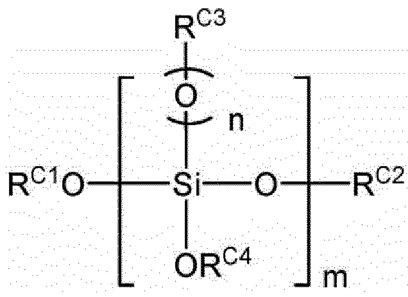

(C1)

where $R^{C1}$ and $R^{C2}$ each independently represent an alkyl group, $R^{C3}$ and $R^{C4}$ each independently represent a hydrogen atom or an alkyl group, n represents 0 or 1, and m represents an integer of 1 or more.

5. Light-emitting particles obtained by the method according to any one of claims 1 to 4.

6. A light-emitting particle dispersion comprising the light-emitting particle according to claim 5 and a dispersion medium.

7. The light-emitting particle dispersion according to claim 6, wherein the dispersion medium is a solvent or a photopolymerizable compound.

8. The light-emitting particle dispersion according to claim 6 or 7, comprising at least a photopolymerizable compound as the dispersion medium and further comprising a photopolymerization initiator.

9. A light conversion film comprising a polymer of the light-emitting particle dispersion according to claim 8.

10. A laminated structure comprising the light conversion film according to claim 9.

11. A light-emitting element comprising the laminated structure according to claim 10.

12. A light conversion layer comprising

a plurality of pixel units; and
a light-shielding unit disposed between the pixel units, wherein
the pixel units include a light-emitting pixel unit containing a cured product of the light-emitting particle dispersion according to claim 8.

**13.** A color filter comprising the light conversion layer according to claim 12.

**14.** A light-emitting element comprising the color filter according to claim 13.

【Fig. 1】

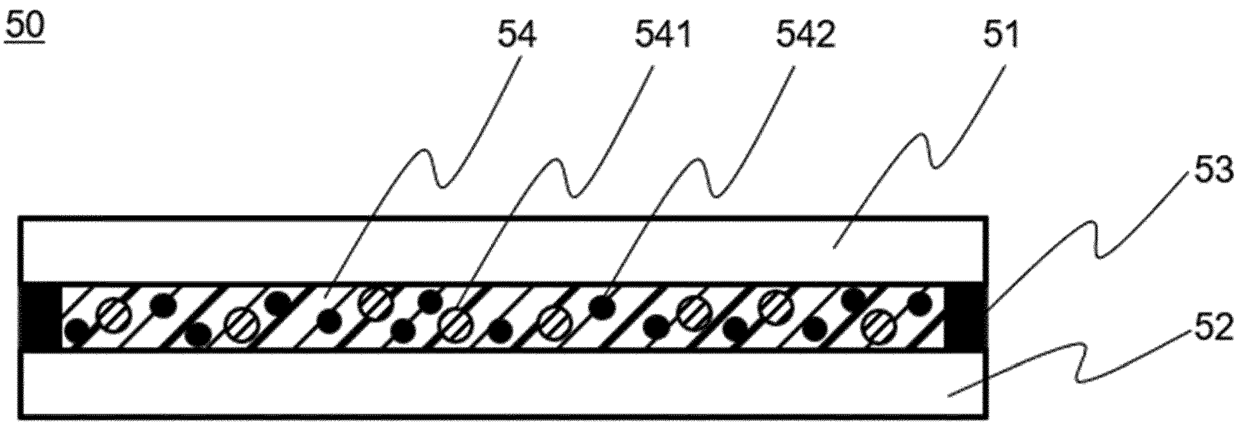

【Fig. 2】

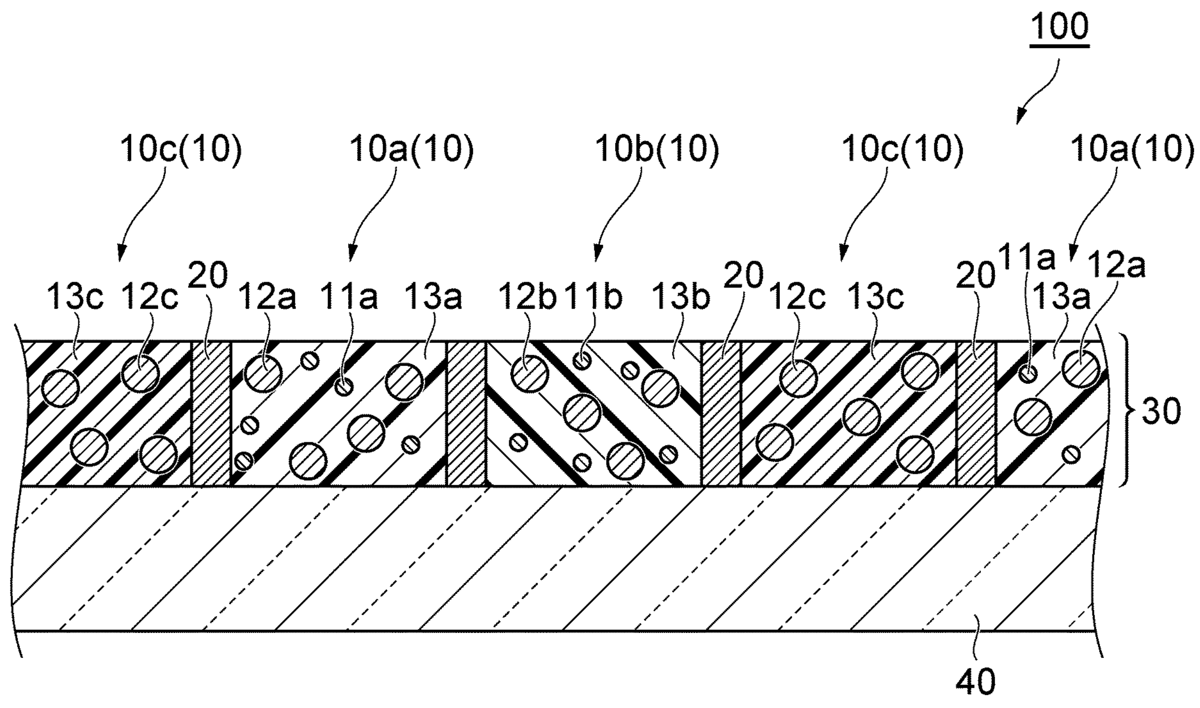
100
10c(10)
10a(10)
10b(10)
10c(10)
10a(10)
13c
12c
20
12a
11a
13a
12b
11b
13b
20
12c
13c
20
11a
13a
12a
30
40

【Fig. 3】

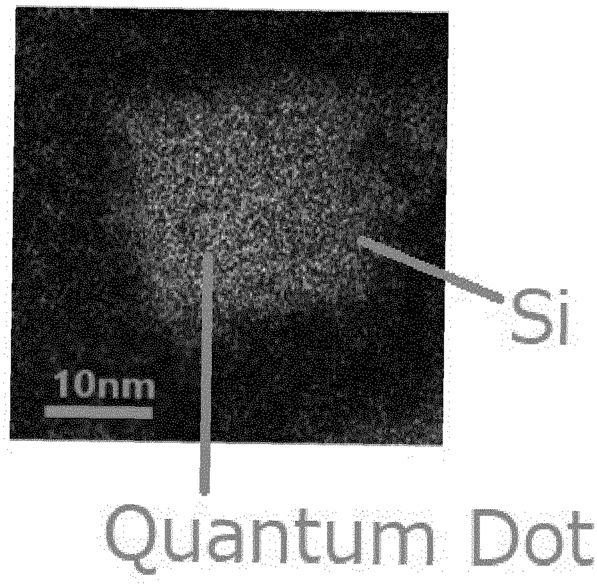

## INTERNATIONAL SEARCH REPORT

International application No.
**PCT/JP2021/040512**

**A. CLASSIFICATION OF SUBJECT MATTER**

***C09K 11/08***(2006.01)i; ***C09K 11/66***(2006.01)i; ***G02B 5/20***(2006.01)i
FI: C09K11/08 G; G02B5/20; G02B5/20 101; C09K11/66; C09K11/08 A

According to International Patent Classification (IPC) or to both national classification and IPC

**B. FIELDS SEARCHED**

Minimum documentation searched (classification system followed by classification symbols)

C09K11/08; C09K11/66; G02B5/20

Documentation searched other than minimum documentation to the extent that such documents are included in the fields searched

Published examined utility model applications of Japan 1922-1996
Published unexamined utility model applications of Japan 1971-2021
Registered utility model specifications of Japan 1996-2021
Published registered utility model applications of Japan 1994-2021

Electronic data base consulted during the international search (name of data base and, where practicable, search terms used)

JSTPlus/JMEDPlus/JST7580 (JDreamIII); CAplus/REGISTRY (STN)

**C. DOCUMENTS CONSIDERED TO BE RELEVANT**

| Category* | Citation of document, with indication, where appropriate, of the relevant passages | Relevant to claim No. |
|---|---|---|
| A | CN 109021283 A (SOUTH CHINA NORMAL UNIVERSITY) 18 December 2018 (2018-12-18)<br>claims, examples, etc. | 1-14 |
| A | CN 108165259 A (EAST CHINA UNIVERSITY OF SCIENCE AND TECHNOLOGY) 15 June 2018 (2018-06-15)<br>claims, examples, etc. | 1-14 |
| A | CN 109266343 A (NANCHANG UNIVERSITY) 25 January 2019 (2019-01-25)<br>claims, examples, etc. | 1-14 |
| A | WO 2020/085513 A1 (SUMITOMO CHEMICAL CO., LTD.) 30 April 2020 (2020-04-30)<br>claims, examples, etc. | 1-14 |
| A | WO 2020/085362 A1 (SUMITOMO CHEMICAL CO., LTD.) 30 April 2020 (2020-04-30)<br>claims, examples, etc. | 1-14 |

☑ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **17 December 2021** | **18 January 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

**INTERNATIONAL SEARCH REPORT**

International application No.
**PCT/JP2021/040512**

**C. DOCUMENTS CONSIDERED TO BE RELEVANT**

| Category* | Citation of document, with indication, where appropriate, of the relevant passages | Relevant to claim No. |
|---|---|---|
| A | HUANG, Shuyi et al., Novel Fluorescence Sensor Based on All-Inorganic Perovskite Quantum Dots Coated with Molecularly Imprinted Polymers for Highly Selective and Sensitive Detection of Omethoate, ACS Applied Materials and Interfaces, vol. 10, 2018, pp. 39056-39063<br>experiments, conclusions, etc. | 1-14 |
| A | TAN, Lei et al., Development of high-luminescence perovskite quantum dots coated with molecularly imprinted polymers for pesticide detection by slowly hydrolysing the organosilicon monomers in situ, Sensors and Actuators B: Chemical, no. 291, 2019, pp. 226-234<br>experiments, results, conclusions, fig. 2, etc. | 1-14 |
| P, A | WO 2020/235480 A1 (DIC CORP.) 26 November 2020 (2020-11-26)<br>claims, examples, etc. | 1-14 |
| P, A | WO 2020/235420 A1 (DIC CORP.) 26 November 2020 (2020-11-26)<br>claims, examples, etc. | 1-14 |
| P, A | JP 2021-91870 A (TOYO INK SC HOLDINGS CO., LTD.) 17 June 2021 (2021-06-17)<br>claims, examples, etc. | 1-14 |
| P, A | JP 2021-102679 A (TOYO INK SC HOLDINGS CO., LTD.) 15 July 2021 (2021-07-15)<br>claims, examples, etc. | 1-14 |

Form PCT/ISA/210 (second sheet) (January 2015)

**INTERNATIONAL SEARCH REPORT**
**Information on patent family members**

International application No.
**PCT/JP2021/040512**

| Patent document cited in search report | Publication date (day/month/year) | Patent family member(s) | Publication date (day/month/year) |
|---|---|---|---|
| CN 109021283 A | 18 December 2018 | (Family: none) | |
| CN 108165259 A | 15 June 2018 | (Family: none) | |
| CN 109266343 A | 25 January 2019 | (Family: none) | |
| WO 2020/085513 A1 | 30 April 2020 | (Family: none) | |
| WO 2020/085362 A1 | 30 April 2020 | (Family: none) | |
| WO 2020/235480 A1 | 26 November 2020 | (Family: none) | |
| WO 2020/235420 A1 | 26 November 2020 | (Family: none) | |
| JP 2021-91870 A | 17 June 2021 | (Family: none) | |
| JP 2021-102679 A | 15 July 2021 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2017222851 A